(19) Europäisches Patentamt / European Patent Office / Office européen des brevets

(11) **EP 2 933 272 B1**

(12) **EUROPEAN PATENT SPECIFICATION**

(45) Date of publication and mention of the grant of the patent:
**17.10.2018 Bulletin 2018/42**

(21) Application number: **13865243.3**

(22) Date of filing: **12.12.2013**

(51) Int Cl.:
*H01L 31/048* (2014.01)   *B32B 17/10* (2006.01)
*C08F 6/22* (2006.01)   *C08F 265/06* (2006.01)
*C08L 29/14* (2006.01)   *C08L 51/04* (2006.01)
*C08F 279/02* (2006.01)

(86) International application number:
**PCT/JP2013/083342**

(87) International publication number:
**WO 2014/097962 (26.06.2014 Gazette 2014/26)**

(54) **SHEET COMPRISING RUBBER-CONTAINING GRAFT POLYMER-POWDER, AND SOLAR CELL OR LAMINATED GLASS USING THE SHEET**

FOLIE UMFASSEND EIN KAUTSCHUKHALTIGES PROPFPOLYMERPULVER, UND SOLARZELL ODER VERBUNDGLAS BEINHALTEND DIE FOLIE

FEUILLE COMPRENANT UNE POUDRE DE POLYMÈRE GREFFÉ CONTENANT DU CAOUTCHOUC, ET CELLULE SOLAIRE OU VERRE STRATIFIÉ UTILISANT LA FEUILLE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.12.2012 JP 2012275180**

(43) Date of publication of application:
**21.10.2015 Bulletin 2015/43**

(73) Proprietors:
• **Kuraray Co., Ltd.**
  **Okayama 710-0801 (JP)**
• **Mitsubishi Chemical Corporation**
  **Tokyo 100-8251 (JP)**

(72) Inventors:
• **MATSUNAGA Yosuke**
  **Otake-shi**
  **Hiroshima 739-0694 (JP)**
• **KASAI Toshihiro**
  **Otake-shi**
  **Hiroshima 739-0694 (JP)**

• **MUGURUMA Shinichi**
  **Kurashiki-shi**
  **Okayama 713-8550 (JP)**
• **YASUDA Hirotaka**
  **Kurashiki-shi**
  **Okayama 713-8550 (JP)**
• **ISOUE Koichiro**
  **Kurashiki-shi**
  **Okayama 713-8550 (JP)**
• **KIURA Masaaki**
  **Otake-shi**
  **Hiroshima 739-0694 (JP)**

(74) Representative: **Müller-Boré & Partner**
  **Patentanwälte PartG mbB**
  **Friedenheimer Brücke 21**
  **80639 München (DE)**

(56) References cited:
**EP-A1- 1 721 936        EP-A2- 2 982 715
WO-A1-2012/026393    WO-A1-2013/002292
JP-A- H07 278 238       JP-A- S61 108 629
JP-A- 2003 040 654**

**Description**

The present invention relates to a sheet comprising a rubber-containing graft polymer powder, and a solar cell or laminated glass using the sheet.

In recent years, from the viewpoint of the effective use of resources or the prevention of environmental pollution, solar cells that convert sunlight directly into electric energy have been widely used, and further development is underway.

As solar cells, a crystalline silicon solar cell, thin film-based silicon, a cadmium telluride solar cell, a CIGS solar cell, a CIS solar cell and the like are exemplified. These solar cells generally have a configuration in which a surface side protective member such as a glass substrate, a solar cell, a back surface side protective member and the like are encapsulated via an encapsulant, are further reinforced by a frame and then constructed.

As a raw material of the encapsulant, it has been proposed to use a polyvinyl butyral (PVB) resin of a thermoplastic resin (see Patent Literatures 1 and 2). The PVB resin is a thermoplastic resin, and thus the resin is highly viscous at the flow beginning temperature and it is less concerned that the resin flows out through the end of glass to contaminate an apparatus or the end surface of the glass when conducting lamination. In addition, from the mechanical point of view as well, an encapsulant using the PVB resin is excellent in adhesive property to glass and penetration resistance. Furthermore, the encapsulant does not require a cross-linking step, and thus it is possible to manufacture a solar cell module by a roll-to-roll process.

However, the encapsulant described in Patent Literatures 1 and 2 generally contains a great amount of a plasticizer as an essential component in addition to PVB in order to improve handling property when winding around a roll and the like. The moisture permeability of the encapsulant is likely to increase by this plasticizer, and thus the solar cell module is discolored by the corrosion of the metal component and the power generation efficiency thereof decreases in some cases when used for a long period of time under a high temperature and a high humidity. Meanwhile, there is a problem that handling property or impact resistance is insufficient when the amount of the plasticizer is decreased in order to reduce the corrosion resistance.

Hitherto, a waterproof sealing treatment to encapsulate the ends of the solar cell module with a sealing material and to cover the solar cell module with a frame has been provided in order to prevent such a decrease in power generation efficiency. The price of the frame is generally about 2 to 4 times as much as the encapsulant, and thus frameless construction is significantly useful for the cost reduction of a solar cell and investigations have been carried out (Non Patent Literature 1). As one of the means to achieve it, an encapsulant having improved corrosion resistance is desired. However, the current frameless module does not exhibit sufficient impact resistance, and thus the back surface is necessary to have a reinforced structure, and as a result, expensive thermally tempered glass is used and additional cost reduction is a challenge to be solved. In addition, a further improvement in durability is desired.

In laminated glass using PVB in an interlayer film as well, the corrosion of the functional material by an acidic component is similarly a problem in some cases in a case in which a functional material such as a thermal barrier material and an electrochromic material is concurrently used, and thus an interlayer film for laminated glass having improved corrosion resistance is desired.

In such a circumstance, a resin composition for laminated glass using a rubber-containing graft polymer powder is known (for example, Patent Literature 3). However, the resin composition for laminated glass containing an acrylic rubber-containing graft polymer powder disclosed in Patent Literature 3 still has room for improvement in impact resistance. Furthermore, there is a problem of poor corrosion resistance when the resin composition is formed into an encapsulant for a solar cell or an interlayer film for laminated glass even in the case of using a rubber-containing graft polymer powder. In addition, an encapsulant is used on the light-receiving surface side in a crystalline silicon solar cell, CIGS and CIS solar cells in many cases, and a high light transmittance (to be excellent in transparency) is one of the important performances required.

   Patent Literature 1: JP 2006-13505 A
   Patent Literature 2: WO 2009/151952 A2
   Patent Literature 3: JP 2003-40654 A

Non Patent Literature 1: "THE SOLAR STANDARD No. 1", [Online], May 2008, APPLIED MATERIALS, [searched in June 2010], Internet <URL: http://www.appliedmaterials.com/products/assets/newsletters/solar_ newsletter_may2008_japan.pdf>

An object of the present invention is to provide a sheet comprising a rubber-containing graft polymer powder, by said powder an encapsulant for a solar cell and an interlayer film for laminated glass that are excellent in corrosion resistance, impact resistance, transparency, weather resistance and economic efficiency can be obtained. In addition, another object of the present invention is to provide a solar cell or laminated glass containing the sheet.

The above objects are achieved by providing a sheet comprising:

a rubber-containing graft polymer powder at from 1 to 100 parts by mass with respect to 100 parts by mass of polyvinyl acetal, wherein
an amount of an acidic component eluted by a hot water test and represented by the following Formula (2) is 3.00 KOHmg/g or less:
[Mathematical Formula 2]

$$\text{(Amount of acidic component eluted by hot water test)} = B \qquad (2),$$

wherein B (unit: KOHmg/g) represents a value obtained by dividing a mass (unit: mg) of potassium hydroxide required to neutralize an acidic component present in water after immersing the sheet in hot water having a mass of 10 times as much as the sheet and having a temperature of 85°C for 1000 hours by a mass (unit: g) of the sheet before being immersed, and
wherein the rubber-containing graft polymer powder is obtained by conducting the graft polymerization of a vinyl monomer in the presence of a rubbery polymer obtained by polymerizing a conjugated diene (x1) and an acrylic acid alkyl ester (x2) having an alkyl group having from 2 to 8 carbon atoms and coagulating this.

It is preferable that the rubber-containing graft polymer powder has 0.10 KOHmg/g or less of an amount of an acidic component eluted by a hot water test and represented by the following Formula (1):
[Mathematical Formula 1]

$$\text{(Amount of acidic component eluted by hot water test)} = A \qquad (1),$$

and
wherein A (unit: KOHmg/g) represents a value obtained by dividing a mass (unit: mg) of potassium hydroxide required to neutralize an acidic component present in water after immersing the rubber-containing graft polymer powder in hot water having a mass of 10 times as much as the rubber-containing graft polymer powder and having a temperature of 85°C for 250 hours by a mass (unit: g) of the rubber-containing graft polymer powder before being immersed.

It is preferable that the rubbery polymer be obtained by polymerizing the conjugated diene (x1) at from 25 to 75% by mass, the acrylic acid alkyl ester (x2) having an alkyl group having from 2 to 8 carbon atoms at from 75 to 25% by mass and copolymerizable another monomer (x3) at from 0 to 5% by mass.

It is preferable that the rubber-containing graft polymer powder be produced by supplying a coagulant containing an alkaline earth metal ion to rubber-containing graft polymer latex obtained by emulsion polymerization and coagulating the latex.

It is preferable that the rubber-containing graft polymer powder be produced by supplying a coagulant containing an alkaline earth metal ion to rubber-containing graft polymer latex obtained by emulsion polymerization using a weak acid-based emulsifier and coagulating the latex.

It is preferable that the weak acid-based emulsifier be a fatty acid-based emulsifier.

It is preferable that a volume average particle size of the rubber-containing graft polymer latex be from 0.13 to 0.80 μm.

It is preferable that a difference in refractive index between a film made of polyvinyl acetal and a film made of the rubber-containing graft polymer powder be 0.02 or less, and a steel ball not penetrate through a laminated body fabricated by adhering glass having a thickness of 2.8 mm to both surfaces of the sheet when being dropped on the laminated body from a height of 2 m in accordance with the penetration resistance test of JIS R 3212.

It is preferable that a steel ball not penetrate through a laminated body fabricated by adhering glass having a thickness of 2.8 mm to both surfaces of the sheet when being dropped on the laminated body from a height of 3 m in accordance with the penetration resistance test of JIS R 3212.

The object of the present invention is achieved by providing a solar cell or laminated glass using the sheet.

According to the present invention, it is possible to provide a sheet comprising a rubber-containing graft polymer powder, by said powder an encapsulant for a solar cell and an interlayer film for laminated glass that are excellent in corrosion resistance, impact resistance, transparency, weather resistance and economic efficiency can be obtained. In addition, it is possible to provide a solar cell or laminated glass using the sheet.

Fig. 1 illustrates an example of a cross-sectional view of a general thin film-based silicon solar cell module.
Fig. 2 illustrates a jig for compression shear strength measurement used to measure adhesive property to glass.

Fig. 3 illustrates a jig for compression shear strength measurement used to measure adhesive property to glass.

[Rubber-containing graft polymer powder]

In the rubber-containing graft polymer powder, an amount of an acidic component eluted by a hot water test and represented by the following Formula (1) is preferably 0.10 KOHmg/g or less, and the amount of the acidic component eluted is more preferably 0.07 KOHmg/g or less, and even more preferably 0.05 KOHmg/g or less:
[Mathematical Formula 3]

$$\text{(Amount of acidic component eluted by hot water test)} = A \qquad (1)$$

[in Formula (1), A (unit: KOHmg/g) represents a value obtained by dividing a mass (unit: mg) of potassium hydroxide required to neutralize an acidic component present in water after immersing the rubber-containing graft polymer powder in hot water having a mass of 10 times as much as the rubber-containing graft polymer powder and having a temperature of 85°C for 250 hours by a mass (unit: g) of the rubber-containing graft polymer powder before being immersed]. When the amount of the acidic component eluted by the hot water test is more than 0.10 KOHmg/g, the decomposition of a polyvinyl acetal resin under a high temperature and a high humidity is promoted when the rubber-containing graft polymer powder is used as a mixture with the polyvinyl acetal resin and the sheet is likely to turn yellow as a result. In addition, the discoloration of the solar cell module due to the corrosion of the metal component is likely to occur and a decrease in power of the solar cell module is concerned as a result. The amount of the acidic component eluted by the hot water test may be a negative value, but it is usually 0 KOHmg/g or more.

The method for measuring the amount of the acidic component eluted by the hot water test is described below. First, 5 g of the rubber-containing graft polymer powder to be the target of measurement is immersed in 50 mL of water and subjected to the immersion treatment at 85°C for 250 hours. Water in which the rubber-containing graft polymer powder has been immersed is transferred to an Erlenmeyer flask after the immersion treatment for 250 hours. At that time, the container in which the rubber-containing graft polymer powder has been immersed is washed twice with 1 mL of water and the water used is recovered. The acid value of the water recovered is measured in accordance with the provision of JIS K6728: 1977 (provided that, 0.02 mol/L sodium hydroxide is used as titrant, and after titration, the number of moles of sodium hydroxide used for titration is converted into the mass of equimolar potassium hydroxide. 50 mL of ion exchanged water is used for blank measurement), and the value obtained by multiplying the acid value (unit: KOHmg/g) thus obtained by the mass (unit: g) of water used is taken as A1 (unit: mg KOH). In addition, the value obtained by dividing the above A1 by 5 g of the mass of the rubber-containing graft polymer powder before being immersed is taken as the above A (unit: KOHmg/g).

In the present invention, it is desirable that the amount of the acidic component eluted from the rubber-containing graft polymer powder by the hot water test satisfies the above range even in a case in which the content of the acidic component in the rubber-containing graft polymer powder represented by the following Formula (3) is high:
[Mathematical Formula 4]

$$\text{(Content of acidic component in rubber-containing graft polymer}$$
$$\text{powder itself)} = C \qquad (3)$$

Hitherto, a rubber-containing graft polymer powder having the amount of the acidic component eluted by the hot water test within the specific range of the present application has not been known. By the present invention, it has been found out that the influence that the amount of the acidic component eluted by the hot water test has, particularly on the corrosion resistance and weather resistance of the encapsulant for a solar cell, is greater than that of the content of the acidic component in the rubber-containing graft polymer powder. The content of the acidic component in the rubber-containing graft polymer powder itself can be measured as follows.

First, 5 g of the rubber-containing graft polymer powder to be the target of measurement is immersed in a mixed solvent of 45 mL of ethanol and 5 mL of water and the mixture is stirred at room temperature for 15 hours. Thereafter, the mixed liquid in which the rubber-containing graft polymer powder has been immersed is transferred to an Erlenmeyer flask. At that time, the container in which the rubber-containing graft polymer powder has been immersed is washed twice with 1 mL of ethanol and the ethanol used is recovered. The acid value of the mixed liquid recovered is measured in accordance with the provision of JIS K6728: 1977, and the value obtained by multiplying the acid value (unit: KOHmg/g) thus obtained by the mass (unit: g) of the mixed liquid is taken as C1 (unit: mg KOH). In addition, the value obtained by dividing the above C1 by 5 g of the mass of the rubber-containing graft polymer powder before being immersed is taken as the above C (unit: KOHmg/g).

In order to set the amount of the acidic component eluted by the hot water test and represented by Formula (1) above within the above range, various methods may be used, such as a method to select the emulsifier used when obtaining the rubber-containing graft polymer, a method to select a coagulant used when coagulating the rubber-containing graft polymer and a method to wash the rubber-containing graft polymer after coagulation, but a method to select a coagulant used when coagulating the rubber-containing graft polymer and a method to wash the rubber-containing graft polymer after coagulation are preferable from the viewpoint of ease of operation.

In the present invention, the rubber-containing graft polymer powder is one obtained by conducting the graft polymerization of a vinyl monomer in the presence of a rubbery polymer to be described below and coagulating this.

[Rubbery polymer]

The rubbery polymer in the present invention is obtained by polymerizing an acrylic acid alkyl ester and/or a conjugated diene. The rubbery polymer is one obtained by polymerizing a monomer (x) containing a conjugated diene (x1) and an acrylic acid alkyl ester (x2) having an alkyl group having from 2 to 8 carbon atoms from the viewpoint of obtaining a rubbery polymer which exhibits excellent impact strength and weather resistance in a good balance. Examples of the conjugated diene (x1) may include 1,3-butadiene, isoprene, 1,3-pentadiene, 2,3-dimethylbutadiene, 2-methyl-1,3-pentadiene, 3-methyl-1,3-pentadiene, 1,3-hexadiene, 2,4-hexadiene, 2-ethyl-1,3-butadiene, 2-phenyl-1,3-butadiene, 1-phenyl-1,3-butadiene, 1,3-diphenyl-1,3-butadiene, 1,4-diphenyl-1,3-butadiene, 2,3-diphenylbutadiene and 1,3-cyclohexadiene.

Examples of the acrylic acid alkyl ester (x2) having an alkyl group having from 2 to 8 carbon atoms may include ethyl acrylate, propyl acrylate, butyl acrylate, isopropyl acrylate, hexyl acrylate and 2-ethylhexyl acrylate. As the acrylic acid alkyl ester (x2) having an alkyl group having from 2 to 8 carbon atoms, one kind may be used singly or two or more kinds may be used concurrently. In particular, butyl acrylate and 2-ethylhexyl acrylate are preferable from the perspective of weather resistance, ease of the adjustment of refractive index, and the like.

In addition to the conjugated diene (x1) and the acrylic acid alkyl ester (x2) having an alkyl group having from 2 to 8 carbon atoms, the monomer (x) may contain another monomer (x3) copolymerizable with these monomers. Examples of the other monomer (x3) copolymerizable with these monomers may include a monofunctional monomer such as a methacrylic acid alkyl ester including methyl methacrylate or acrylonitrile, and a multifunctional monomer such as divinyl benzene, ethylene glycol dimethacrylate, butylene glycol diacrylate, triallyl cyanurate, triallyl isocyanurate, trimethylolpropane triacrylate and pentaerythritol tetraacrylate. As the copolymerizable other monomer (x3), one kind may be used singly or two or more kinds may be used concurrently.

As the composition of the monomer (x), it is preferable that the conjugated diene (x1) be from 1 to 99% by mass, the acrylic acid alkyl ester (x2) having an alkyl group having from 2 to 8 carbon atoms is from 1 to 99% by mass, and the copolymerizable other monomer (x3) is from 0 to 10% by mass when the total amount of the monomer (x) is 100% by mass. It is more preferable that the conjugated diene (x1) be from 25 to 75% by mass, the acrylic acid alkyl ester (x2) be from 25 to 75% by mass, and the copolymerizable other monomer (x3) be from 0 to 5% by mass. It is most preferable that the conjugated diene (x1) be from 40 to 50% by mass, the acrylic acid alkyl ester (x2) be from 50 to 60% by mass, and the copolymerizable other monomer (x3) be from 0 to 5% by mass. It is possible to obtain a molded article excellent in impact resistance and weather resistance, as the composition is within the above range.

The rubbery polymer can be obtained by a known emulsion polymerization method. For example, it may be obtained by setting the temperature of a mixture of the monomer (x), an emulsifier and water to a predetermined temperature and then adding a polymerization initiator thereto.

As the emulsifier, a known emulsifier can be used, and it is preferable to use a weak acid-based emulsifier and it is more preferable to use a fatty acid-based emulsifier. For the rubber-containing graft polymer powder described hereafter, in order to set the amount of the acidic component eluted by the hot water test and represented by Formula (1) within a predetermined range, it is important to select the emulsifier and coagulant such that the salt formed from the emulsifier remaining in the rubber-containing graft polymer and the coagulant used for coagulation is hardly ionized when coagulating the rubber-containing graft polymer, and the combination of a weak acid-based emulsifier and a coagulant containing an alkaline earth metal ion as the coagulant is preferable and the combination of a fatty acid-based emulsifier and a coagulant containing an alkaline earth metal ion is more preferable from the viewpoint that the amount of the acidic component eluted by the hot water test can be decreased.

The weak acid-based emulsifier refers to a salt formed from a weak acid and a strong base among emulsifiers. Examples of the weak acid-based emulsifier may include a fatty acid-based emulsifier such as a fatty acid potassium including potassium octanoate, potassium decanoate, potassium laurate and potassium palmitate; a fatty acid sodium including sodium octanoate, sodium decanoate, sodium laurate and sodium palmitate; sodium N-lauroylsarcosinate; dipotassium alkenylsuccinate; and rosin acid soap. One kind of these emulsifiers may be used singly or two or more kinds thereof may be used concurrently. Among these, it is preferable to use a fatty acid-based emulsifier and sodium N-lauroylsarcosinate and it is particularly preferable to use sodium N-lauroylsarcosinate from the perspective of ease of handling, ease of availability and the like.

As the polymerization initiator, a thermal decomposition type initiator such as potassium persulfate and ammonium persulfate or a redox type initiator that is a combination of an organic peroxide such as cumene hydroperoxide, t-butyl hydroperoxide and diisopropylbenzene hydroperoxide, and an iron compound, sodium ethylenediaminetetraacetate and sodium formaldehyde sulfoxylate is used. It is also possible to use sodium pyrophosphate instead of sodium ethylenediaminetetraacetate and dextrose instead of sodium formaldehyde sulfoxylate.

A chain transfer agent such as mercaptan may be used at the time of polymerization for the purpose of, for example, adjusting the molecular weight.

The volume average particle size of rubbery polymer latex [I] obtained by the emulsion polymerization of the monomer (x) is preferably within the range of from 0.12 to 0.60 $\mu$m, and more preferably from 0.15 to 0.50 $\mu$m. It is possible to obtain a sheet which is excellent in impact resistance and has a favorable appearance when the volume average particle size of the rubbery polymer latex [I] is within this range. The method for measuring the volume average particle size is not particularly limited, but it is convenient to measure the volume average particle size by a dynamic light scattering method or a turbidimetric method.

[Enlargement and enlarging agent]

The rubbery polymer can be obtained as enlarged rubbery polymer latex [I'] by adding an enlarging agent to the rubbery polymer latex [I] to enlarge the particles in order to set the volume average particle size of the rubber-containing graft polymer powder within a preferred range.

The enlarging agent can be arbitrarily selected from those which are known, but it is preferable to use an acid group-containing copolymer (A) and/or an oxyacid salt (B).

As the acid group-containing copolymer (A), those which are obtained by polymerizing an unsaturated acid, an acrylic acid alkyl ester and another copolymerizable monomer are preferable.

The unsaturated acid used in the polymerization of the acid group-containing copolymer (A), for example, consists of at least one kind selected from acrylic acid, methacrylic acid, itaconic acid, crotonic acid, maleic acid, fumaric acid, cinnamic acid, sorbic acid and p-styrenesulfonic acid. Among these, acrylic acid and methacrylic acid are preferable from the viewpoint of ease of availability and ease of handling.

As the acrylic acid alkyl ester used in the polymerization of the acid group-containing copolymer (A), at least one kind of acrylic acid alkyl ester having an alkyl group having from 1 to 12 carbon atoms is preferable. Specific examples of the acrylic acid alkyl ester used in the polymerization of the acid group-containing copolymer (A) may include methyl acrylate, ethyl acrylate, propyl acrylate, butyl acrylate, isopropyl acrylate, hexyl acrylate, 2-ethylhexyl acrylate, stearyl acrylate, and the like.

Examples of the other copolymerizable monomer may include a styrene derivative such as styrene and $\alpha$-methylstyrene and acrylonitrile.

As the proportion of the monomers used in the acid group-containing copolymer (A), it is preferable that the unsaturated acid be from 3 to 40% by mass, the acrylic acid alkyl ester be from 97 to 35% by mass and the other copolymerizable monomer is from 0 to 40% by mass when the total amount of the monomers used in the acid group-containing copolymer (A) is 100% by mass, and it is more preferable that the unsaturated acid be from 5 to 35% by mass, the acrylic acid alkyl ester be from 95 to 30% by mass and the other copolymerizable monomer be from 0 to 35% by mass. As the composition is within the above range, excellent stability of the latex is exhibited when conducting enlargement and it is easy to control the volume average particle size of the rubbery polymer obtained by the enlargement.

The acid group-containing copolymer (A) can be obtained by polymerizing a monomer mixture having the above composition by a known emulsion polymerization method.

The oxyacid salt (B) is preferably an oxyacid alkali metal salt containing an element selected from the element group belonging to the second and third periods of Group IIIB to Group VIB in the periodic table of the elements or at least one or more kinds of oxyacid salts (B) selected from an alkaline earth metal salt, or a zinc salt, a nickel salt and an aluminum salt. Examples of such an oxyacid salt (B) may include salts of sulfuric acid, nitric acid, phosphoric acid, and the like with potassium, sodium, magnesium, calcium, nickel and aluminum. As the oxyacid salt (B), potassium sulfate, sodium sulfate, magnesium sulfate, aluminum sulfate, sodium phosphate, magnesium phosphate and the like are preferable from the viewpoint of ease of controllability of the particle size at the time of conducting enlargement, availability, and handling.

As each of these acid group-containing copolymer (A) and oxyacid salt (B), one kind may be used singly or two or more kinds may be used concurrently.

In a case in which one kind is used singly as each of these acid group-containing copolymer (A) and the oxyacid salt (B), the amount of the acid group-containing copolymer latex added is preferably from 0.1 to 5 parts by mass, and more preferably from 0.5 to 3 parts by mass per 100 parts by mass of the rubbery polymer as the solid matter of polymer. In addition, the amount of the oxyacid salt (B) added is preferably from 0.1 to 5 parts by mass, and more preferably from 0.1 to 4 parts by mass per 100 parts by mass of the rubbery polymer. As the acid group-containing copolymer (A) and the oxyacid salt (B) are added within these ranges, the enlargement of the rubbery polymer latex [I] is more efficiently conducted and the stability of the enlarged rubbery polymer latex [I'] to be obtained is also greatly improved.

The pH of the rubbery polymer latex [I] is preferably 7 or more in the case of conducting the enlargement treatment using the acid group-containing copolymer (A). In a case in which the pH value indicates that the latex [I] is acidic, the enlargement efficiency may be low even though the acid group-containing copolymer latex is added and thus it may not be possible to advantageously produce the composition intended by the present invention in some cases.

The volume average particle size of the enlarged rubbery polymer latex [I'] obtained is preferably within the range of from 0.12 to 0.60 $\mu$m, and more preferably from 0.15 to 0.50 $\mu$m. It is possible to obtain a sheet which is excellent in impact resistance and has a favorable appearance when the volume average particle size of the enlarged rubbery polymer latex [I'] is within this range. The method for measuring the volume average particle size is not particularly limited, but it is convenient to measure the volume average particle size by a dynamic light scattering method or a turbidimetric method.

[Rubber-containing graft polymer]

The rubber-containing graft polymer is one obtained by the graft polymerization of a vinyl monomer in the presence of the rubbery polymer. The rubber-containing graft polymer can be obtained, for example, by the graft polymerization of a vinyl monomer in the presence of the rubbery polymer latex [I] or the enlarged rubbery polymer latex [I'].

The vinyl monomer used in the graft polymerization can be appropriately selected depending on the glass transition temperature and refractive index of the rubber-containing graft polymer. It is preferable to use a monomer mixture comprising methyl methacrylate, an acrylic acid alkyl ester having an alkyl group having from 1 to 8 carbon atoms and/or styrene from the viewpoint of ease of handling and ease of adjustment of the refractive index.

Specific examples of the acrylic acid alkyl ester having an alkyl group having from 1 to 8 carbon atoms may include methyl acrylate, ethyl acrylate, propyl acrylate, butyl acrylate, isopropyl acrylate, hexyl acrylate, 2-ethylhexyl acrylate and the like. Among these, methyl acrylate, ethyl acrylate and butyl acrylate are preferable from the viewpoint of ease of adjustment of the refractive index and availability.

As the composition of the monomer mixture, it is preferable that methyl methacrylate be from 50 to 100% by mass and the acrylic acid alkyl ester having an alkyl group having from 1 to 8 carbon atoms and/or styrene is from 0 to 50% by mass per 100% by mass of the monomer constituting the graft part. As these monomers, one kind can be used singly or two or more kinds may be used concurrently. It is possible to obtain a sheet which is excellent in transparency as the composition is within the above range.

The rubber-containing graft polymer can be obtained by a known emulsion polymerization method. The rubber-containing graft polymer can be obtained, for example, by adding an emulsifier in the presence of the rubbery polymer and adding a mixture of the monomer and a polymerization initiator to conduct the polymerization while maintaining the temperature at a predetermined value.

As the emulsifier, the same emulsifier as those used when polymerizing the rubbery polymer may be used. Known emulsifiers may be used, and a weak acid-based emulsifier is preferable and a fatty acid-based emulsifier is more preferable from the viewpoint that it is possible to decrease the amount of the acidic component eluted by the hot water test by combining with a coagulant containing an alkaline earth metal ion as a coagulant. Among them, it is particularly preferable to use sodium N-lauroylsarcosinate from the perspective of ease of handling, availability and the like.

As the polymerization initiator, the same polymerization initiator as those used when polymerizing the rubbery polymer may be used.

A chain transfer agent such as mercaptan may be used at the time of polymerization for the purpose of, for example, adjusting the molecular weight and the like.

The vinyl monomer is preferably set to be from 10 to 1,000 parts by mass, and more preferably from 20 to 800 parts by mass with respect to 100 parts by mass of the rubbery polymer. Fluidity and processability become favorable as the vinyl monomer is 10 parts by mass or more and a rubber-containing graft polymer excellent in impact resistance is obtained as the vinyl monomer is set to be 1000 parts by mass or less.

The volume average particle size of the rubber-containing graft polymer latex obtained by the graft polymerization of the vinyl monomer in the presence of the rubbery polymer latex [I] or the enlarged rubbery polymer latex [I'] is preferably from 0.13 to 0.80 $\mu$m, and more preferably from 0.15 to 0.70 $\mu$m from the viewpoint of improving impact resistance. As the method for measuring the volume average particle size, for example, a method by a dynamic light scattering method or a turbidimetric method is convenient.

[Rubber-containing graft polymer powder]

In order to recover the rubber-containing graft polymer powder from the latex obtained after the graft polymerization is completed, an additive such as an antioxidant is added to the latex if necessary and the latex is coagulated by a known method to use an aqueous solution of a coagulant.

The coagulant is not particularly limited, and known ones may be used. It is preferable to use a coagulant containing an alkaline earth metal ion since the amount of the acidic component eluted from the rubber-containing graft polymer powder by the hot water test and represented by Formula (1) can be set to be within a predetermined range by the combination with a weak acid-based emulsifier.

Examples of the coagulant containing an alkaline earth metal ion may include calcium acetate, calcium chloride, and the like. Among these, it is particularly preferable to use calcium acetate from the viewpoint of ease of handling.

The flour obtained by coagulation is dehydrated, washed and then dried to obtain as a powder.

In order to set the amount of the acidic component eluted from the rubber-containing graft polymer powder by the hot water test and represented by Formula (1) to be within a predetermined range, it is possible to use a technique to sufficiently wash away the salt or the ion in the washing step in addition to select the combination of an emulsifier and a coagulant so that the salt formed is hardly ionized.

In the washing step, it is preferable to wash the flour obtained with deionized water of 5 times or more and preferably 10 times or more as much as the mass of the flour. It is possible to sufficiently wash away the salt and the ion formed in the coagulating step and to suppress the formation of an acid by conducting the washing with deionized water of 5 times or more as much as the mass of the flour.

Washing with deionized water may be conducted after conducting the preliminary washing with an aqueous solution of sodium carbonate, sodium acetate, sodium hydrogen carbonate, sodium hydrogen phosphate, potassium hydrogen carbonate, dipotassium hydrogen phosphate, ammonium hydrogen carbonate or the like for the purpose to remove the ion remaining and to maintain the pH of the flour to be weakly alkaline.

From the viewpoint of further improving the impact resistance of the sheet, the glass transition temperature of the rubber-containing graft polymer powder is preferably -10°C or lower, more preferably - 20°C or lower, and even more preferably -30°C or lower. The lower limit of the glass transition temperature of the rubber-containing graft polymer powder is not particularly limited, but the glass transition temperature of the rubber-containing graft polymer powder is preferably -200°C or higher, and more preferably -150°C or higher. As the method for measuring the glass transition temperature, the glass transition temperature is measured on the basis of JIS K 7244-4: 1999 and the peak value of tan $\delta$ is adopted in the same manner as in Examples to be described hereafter.

The transparency of the interlayer film for laminated glass is also important in the case of using the sheet of the present invention as the interlayer film for laminated glass in an architectural application. From the viewpoint of maintaining the transparency of the interlayer film for laminated glass, the difference in refractive index between the rubber-containing graft polymer powder and the polyvinyl acetal resin is preferably 0.02 or less, more preferably 0.01 or less, and even more preferably 0.005 or less. Hence, it is important to properly adjust the refractive index by copolymerizing an acrylic acid alkyl ester and/or styrene and the like in the graft polymerization step so that the rubber-containing graft polymer powder has an intended refractive index.

From the viewpoint of improving the impact resistance of the sheet, the content of the rubber-containing graft polymer powder is preferably from 1 to 100 parts by mass, more preferably from 3 to 80 parts by mass, and even more preferably from 5 to 60 parts by mass with respect to 100 parts by mass of the polyvinyl acetal resin. The effect of improving impact resistance tends to decrease when the content of the rubber-containing graft polymer powder is less than 1 part by mass. On the other hand, it is not preferable that the content of the rubber-containing graft polymer powder be more than 100 parts by mass since the adhesive force with the glass decreases or the fluidity of the sheet to be obtained decreases and thus lamination tends to be difficult. The amount of the rubber-containing graft polymer powder added may be appropriately selected depending on the composition of the polyvinyl acetal resin used, the average degree of polymerization and the like.

[Polyvinyl acetal]

The sheet of the present invention contains polyvinyl acetal. The content proportion thereof is preferably 40% by mass or more, more preferably 50% by mass or more, and even more preferably 60% by mass or more. Corrosion resistance or adhesive property to glass tends to be insufficient when the content of polyvinyl acetal is less than 40% by mass. In addition, in the sheet of the present invention, it is also possible to mix a resin other than polyvinyl acetal and to use a laminated body of polyvinyl acetal and a resin other than polyvinyl acetal as an encapsulant for a solar cell or an interlayer film for laminated glass as long as it is not contrary to the spirit of the present invention. In addition, it is also possible to mix an inorganic substance (titanium oxide, talc and the like).

As polyvinyl acetal, those which have an average degree of acetalization of from 40 to 90% by mole are preferable. It is not preferable that the average degree of acetalization be less than 40% by mole since the coefficient of water absorption of the sheet increases. It takes a long reaction time for obtaining polyvinyl acetal and thus it may not be preferable regarding the reaction process in some cases when the average degree of acetalization is more than 90% by mole. The average degree of acetalization is more preferably from 60 to 85% by mole, and even more preferably from 65 to 80% by mole from the viewpoint of water resistance. The average degree of acetalization is based on the vinyl acetal component in polyvinyl acetal described hereafter.

As polyvinyl acetal, those which contain a vinyl acetate component in polyvinyl acetal at 20% by mole or less are preferable, those which contain a vinyl acetate component at 5% by mole or less are more preferable, and those which contain a vinyl acetate component at 2% by mole or less are even more preferable. It is not preferable that the vinyl acetate component be more than 20% by mole since blocking is caused at the time of producing polyvinyl acetal to have difficulty in producing and also there is a possibility that the acetate group is converted into a carboxyl group by hydrolysis under a high temperature and a high humidity.

Polyvinyl acetal is usually composed of a vinyl acetal component, a vinyl alcohol component and a vinyl acetate component, and the amount of each of these components can be measured, for example, based on the "Polyvinyl Butyral Test Method" of JIS K 6728: 1977 or a nuclear magnetic resonance (NMR) method.

In a case in which polyvinyl acetal contains a component other than the vinyl acetal component, the amount of the vinyl acetal component of the remainder can be calculated usually by measuring the amount of the vinyl alcohol component and the amount of the vinyl acetate component and subtracting the amounts of these two components from the total amount of polyvinyl acetal.

As polyvinyl acetal used in the present invention, it is possible to use those obtained by reacting an aldehyde described hereafter with polyvinyl alcohol. Such polyvinyl acetal can be produced by a known method.

Polyvinyl alcohol used as a raw material of polyvinyl acetal can be obtained, for example, by polymerizing a vinyl ester-based monomer and saponifying the polymer obtained. As the method for polymerizing the vinyl ester-based monomer, it is possible to apply a method known in the art such as a solution polymerization method, a bulk polymerization method, a suspension polymerization method and an emulsion polymerization method. As the polymerization initiator, an azo-based initiator, a peroxide-based initiator, a redox-based initiator and the like are appropriately selected depending on the polymerization method. As the saponification reaction, it is possible to apply alcoholysis, hydrolysis and the like which are known in the art and use an alkali catalyst or an acid catalyst, and among these, a saponification reaction to use methanol as a solvent and a caustic soda (NaOH) catalyst is simple and thus it is even more preferable.

It is preferable to set the amount of vinyl acetate in polyvinyl acetal to be obtained to be within the above range, and thus the degree of saponification of polyvinyl alcohol to be a raw material is preferably 80% by mole or more, more preferably 95% by mole or more, and even more preferably 98% by mole or more.

Examples of the vinyl ester-based monomer may include vinyl formate, vinyl acetate, vinyl propionate, vinyl butyrate, vinyl isobutyrate, vinyl pivalate, vinyl versatate, vinyl caproate, vinyl caprylate, vinyl laurate, vinyl palmitate, vinyl stearate, vinyl oleate, vinyl benzoate and the like, and vinyl acetate is preferable among these. In addition, it is also possible to copolymerize the vinyl ester-based monomer with another monomer such as $\alpha$-olefin within a range in which the gist of the present invention is not impaired in the case of polymerizing the vinyl ester-based monomer.

As polyvinyl alcohol used as a raw material of polyvinyl acetal, those which have an average degree of polymerization of from 100 to 5000 are preferable, those which have an average degree of polymerization of from 400 to 3000 are more preferable, those which have an average degree of polymerization of from 600 to 2500 are even more preferable, those which have an average degree of polymerization of from 700 to 2300 are particularly preferable, and those which have an average degree of polymerization of from 750 to 2000 are most preferable. When the average degree of polymerization of polyvinyl alcohol is too low, there are some cases in which the penetration resistance and creep resistance property, particularly creep resistance property under a high temperature and high humidity condition such as 85°C and 85% RH of the solar cell module to be obtained decrease. On the other hand, when the average degree of polymerization is more than 5000, there are some cases in which molding of the resin film is difficult. In addition, in order to improve the lamination suitability of the sheet to be obtained and to obtain a solar cell module or laminated glass superior in appearance, the average degree of polymerization of polyvinyl alcohol is preferably 1500 or less, more preferably 1100 or less, and even more preferably 1000 or less in a system to which a plasticizer is not added. In addition, it is preferable to use polyvinyl alcohol having a higher average degree of polymerization in a system to which a plasticizer is added, and the average degree of polymerization is preferably 2500 or less, and more preferably 2000 or less. The average degree of polymerization of polyvinyl acetal is consistent with the average degree of polymerization of polyvinyl alcohol of a raw material, and thus the preferred average degree of polymerization of polyvinyl alcohol described above is consistent with the preferred average degree of polymerization of polyvinyl acetal.

The average degree of polymerization of polyvinyl alcohol can be measured, for example, based on the "Polyvinyl Alcohol Test Method" of JIS K 6726.

The solvent used in the production of polyvinyl acetal is not particularly limited, but it is preferable to use water regarding the industrial mass production, and it is preferable to sufficiently dissolve polyvinyl alcohol under a high temperature, for example, a temperature of 90°C or higher in advance prior to the reaction. In addition, the concentration of the aqueous solution in which polyvinyl alcohol is dissolved is preferably from 5 to 40% by mass, more preferably from 6 to 20% by mass, and even more preferably from 7 to 15% by mass. The productivity is poor when the concentration of the aqueous solution in which polyvinyl alcohol is dissolved is too low. On the other hand, it is not preferable that the concentration of the aqueous solution be too high since stirring during the reaction is difficult and gelation by the intermolecular hydrogen bond of polyvinyl alcohol occurs, and thus an uneven reaction takes place.

Polyvinyl acetal can be produced by adding aldehydes to the aqueous solution of polyvinyl alcohol to subject to a reaction. A catalyst used here may be either an organic acid or an inorganic acid, and examples thereof may include acetic acid, p-toluenesulfonic acid, hydrochloric acid, nitric acid, sulfuric acid, carbonic acid and the like. Among these, hydrochloric acid, nitric acid and sulfuric acid are preferable since a sufficient reaction velocity is achieved and washing after the reaction is easy, and nitric acid is more preferable since handling property is easy. The concentration of the catalyst in the aqueous solution of polyvinyl alcohol after the addition of the catalyst is preferably from 0.01 to 5 mol/L, and more preferably from 0.1 to 2 mol/L in the case of hydrochloric acid, sulfuric acid and nitric acid although it depends on the kind of the catalyst used. It is not preferable that the concentration of the catalyst be too low since the reaction velocity is slow and thus it takes time to obtain polyvinyl acetal having an intended degree of acetalization and intended physical properties. On the other hand, it is not preferable that the concentration of the catalyst be too high since a trimer of the aldehyde is easily formed as well as it is difficult to control the acetalization reaction.

Here, as the aldehydes, for example, formaldehyde, acetaldehyde, propionaldehyde, butyraldehyde, hexyl aldehyde, benzaldehyde and the like are used. An aldehyde compound having from 1 to 12 carbon atoms is preferable, a saturated alkyl aldehyde compound having from 1 to 6 carbon atoms is more preferable and a saturated alkyl aldehyde compound having from 1 to 4 carbon atoms is even more preferable. Among them, butyl aldehyde is preferable from the viewpoint of the mechanical properties of the sheet. In addition, one kind of aldehydes may be used singly or two or more kinds thereof may be used concurrently. In particular, it is preferable to use butyraldehyde and acetaldehyde concurrently from the viewpoint that the glass transition temperature of polyvinyl acetal can be controlled. Furthermore, a small amount of polyfunctional aldehydes or other aldehydes having a functional group may be used concurrently within a range of 20% by mass or less of the total aldehydes.

As the procedure for the acetalization reaction, a known method may be exemplified, and examples thereof may include a method in which the catalyst is added to the aqueous solution of polyvinyl alcohol and the aldehydes are then added and a method in which the aldehydes are previously added and the catalyst is then added. In addition, a method in which the aldehydes or catalyst to be added is added at once, sequentially or in a divided manner or a method in which a mixed solution of the aqueous solution of polyvinyl alcohol and the aldehydes or the catalyst is added to the solution containing the catalyst or the aldehydes may be also exemplified.

The reaction temperature of the acetalization reaction is not particularly limited, but it is preferable to conduct the reaction at a relatively low temperature of from 0 to 40°C and it is more preferable to conduct the reaction at from 5 to 20°C until the particles of polyvinyl acetal are precipitated in the middle of the reaction from the viewpoint of producing porous polyvinyl acetal to be easily washed after the reaction in order to improve the corrosion resistance of the sheet. It is concerned that polyvinyl acetal is fused to be rarely porous when the reaction temperature is higher than 40°C. After the reaction is conducted at a relatively low temperature of from 0 to 40°C, it is preferable to raise the reaction temperature to from 50 to 80°C and it is more preferable to raise it to from 65 to 75°C in order to increase the productivity by accelerating the reaction.

As the method for removing the aldehydes and the catalyst that remain after the acetalization reaction, a known method is exemplified. Polyvinyl acetal obtained by the reaction is neutralized by an alkali compound, but it is preferable to remove the aldehydes remaining in polyvinyl acetal as much as possible prior to the neutralization. For this reason, a method to accelerate the reaction under the condition that increase the reaction rate of the aldehydes, a method to sufficiently wash with water, a mixed solvent of water/alcohol or the like and a method to chemically treat the aldehyde are useful. Examples of the alkali compound used for the neutralization may include an alkali metal hydroxide such as sodium hydroxide and potassium hydroxide or an amine-based compound such as ammonia, trimethylamine and pyridine. Among these, an alkali metal hydroxide which has less influence on the adhesive property with glass is even more preferable.

Polyvinyl acetal obtained by the method described above is decomposed by an acid in the presence of water to produce aldehydes and thus it is preferable to adjust the alkali titer value to be a positive value. The alkali titer value of polyvinyl acetal after the alkali neutralization is preferably from 0.1 to 30, more preferably from 1 to 20, and even more preferably from 1 to 10. It is concerned that the hydrolysis easily proceeds when the alkali titer value is less than 0.1, and conversely it is concerned that the coloring easily occurs at the time of manufacturing a sheet of polyvinyl acetal when the alkali titer value is more than 30. Here, the alkali titer value is the quantity (mL) of 0.01 mol/L hydrochloric acid required to titrate the alkali component in 100g of polyvinyl acetal by neutralization.

The acid value of polyvinyl acetal obtained by the method described above is preferably 0.50 KOHmg/g or less, more preferably 0.30 KOHmg/g or less, even more preferably 0.10 KOHmg/g or less and particularly preferably 0.06 KOHmg/g or less. When the acid value of polyvinyl acetal is more than 0.50 KOHmg/g, the coloring caused by a great amount of the acidic component may occur in the sheet to be obtained or the electrode of the solar cell module to be obtained is corroded to cause a decrease in lifespan. Here, the acid value of polyvinyl acetal is a value measured in accordance with JIS K6728: 1977.

[Other additives]

The sheet of the present invention may further contain a plasticizer, an adhesive force modifier, an antioxidant, an ultraviolet absorber, a light stabilizer, a blocking inhibitor, a pigment, a dye, a functional inorganic compound and the like if necessary within the range in which the effect of the present invention is not impaired.

In a case in which the sheet of the present invention contains a plasticizer, the content thereof is preferably from 0 to 40 parts by mass or less with respect to 100 parts by mass of polyvinyl acetal. The plasticizer is mainly used for the purpose to improve fluidity and impact resistance. It is not preferable that the plasticizer be more than 40 parts by mass since the mechanical properties of the film decrease and the handling is difficult. In addition, it is not preferable since it is concerned that the amount of the acidic component contained as an impurity in the plasticizer increases in the application as an encapsulant for a solar cell or the moisture permeability increases by the plasticizing effect so as to allow water to easily infiltrate and thus a problem such as a decrease in power or discoloration of the solar cell module under a high temperature and a high humidity occurs. Hence, in the application as an encapsulant for a solar cell, the content of the plasticizer is preferably 10 parts by mass or less, more preferably 5 parts by mass or less, even more preferably 2 parts by mass or less and may be 0 part by mass (that is, a plasticizer may not be used) with respect to 100 parts by mass of polyvinyl acetal.

The acid value of the plasticizer is preferably 0.50 KOHmg/g or less, more preferably 0.30 KOHmg/g or less, even more preferably 0.10 KOHmg/g or less and particularly preferably 0.06 KOHmg/g or less. In a case in which the acid value of the plasticizer is more than 0.50 KOHmg/g, it is concerned that the sheet may be colored or produces a decomposed gas and thus the lifespan of the solar cell module to be obtained may be shortened or the long-term durability of the sheet as the interlayer film for laminated glass may decrease. Here, the acid value of the plasticizer is a value measured in accordance with JIS K6728: 1977.

The plasticizer is not particularly limited, but examples thereof may include triethylene glycol di(2-ethylhexanoate) (3GO), tetraethylene glycol di(2-ethylhexanoate), di-(2-butoxyethyl) adipate (DBEA), di-(2-butoxyethyl) sebacate (DBES), di-(2-butoxyethyl) azelate, di-(2-butoxyethyl) glutarate, di-(2-butoxyethyl) phthalate, di-(2-butoxyethoxyethyl) adipate (DBEEA), di-(2-butoxyethoxyethyl) sebacate (DBEES), di-(2-butoxyethoxyethyl) azelate, di-(2-butoxyethoxyethyl) glutarate, di-(2-butoxyethoxyethyl) phthalate, di-(2-hexoxyethyl) adipate, di-(2-hexoxyethyl) sebacate, di-(2-hexoxyethyl) azelate, di-(2-hexoxyethyl) glutarate, di-(2-hexoxyethoxyethyl) adipate, di-(2-hexoxyethoxyethyl) sebacate, di-(2-hexoxyethoxyethyl) azelate, di-(2-hexoxyethoxyethyl) glutarate, and diisononyl 1,2-cyclohexanedicarboxylate (DINCH) and the like. Among these, a plasticizer of which the sum of the number of carbon atoms and the number of oxygen atoms that constitute the molecule of the plasticizer is more than 28 is preferable. In particular, the acid value increases as the thermal decomposition or hydrolysis occurs under a high temperature and a high humidity when the sum of the number of carbon atoms and the number of oxygen atoms that constitute the molecule of the plasticizer is 28 or less and thus the concentration of the acid tends to increase in the sheet. Preferred examples thereof may include triethylene glycol di(2-ethylhexanoate) (3GO), tetraethylene glycol di(2-ethylhexanoate), di-(2-butoxyethoxyethyl) adipate (DBEEA), di-(2-butoxyethoxyethyl) sebacate (DBEES), diisononyl 1,2-cyclohexanedicarboxylate (DINCH) and the like. Among these, triethylene glycol di(2-ethylhexanoate) (3GO) and diisononyl 1,2-cyclohexanedicarboxylate (DINCH) are preferable from the viewpoint that it is possible to obtain the desired plasticizing effect by a small amount without decreasing the corrosion resistance of the sheet. One kind of such a plasticizer may be used singly or two or more kinds thereof may be used concurrently.

As the adhesive force modifier, for example, those which are disclosed in WO 03/033583 A1 can be used, and an alkali metal salt and an alkaline earth metal salt are preferably used and examples thereof may include salts of potassium, sodium, magnesium and the like. Examples of the salt may include a salt of an organic acid such as carboxylic acid including octanoic acid, hexanoic acid, butyric acid, acetic acid and formic acid; and a salt of an inorganic acid such as hydrochloric acid and nitric acid. The optimal amount of the adhesive force modifier added varies depending on the additive used, but it is preferable that the adhesive force of the sheet to be obtained to glass be adjusted to be generally from 3 to 10 in the pummel test (described in WO 03/033583 A1 and the like), to be from 3 to 6 particularly in a case in which high penetration resistance is required and to be from 7 to 10 in a case in which high glass shatterproof property is required. It is also a useful method that the adhesive force modifier is not added in a case in which high glass shatterproof property is required. In addition, a silane coupling agent is exemplified as various kinds of additives for improving the adhesive property of the sheet. The amount of the silane coupling agent added is preferably from 0.01 to 5% by mass on the basis of the mass of the sheet.

Examples of the antioxidant may include a phenol-based antioxidant, a phosphorus-based antioxidant and a sulfur-based antioxidant, and among these, a phenol-based antioxidant is preferable and an alkyl-substituted phenol-based antioxidant is particularly preferable. These antioxidants may be used singly or in combination of two or more kinds thereof. The amount of the antioxidant blended is preferably from 0.001 to 5 parts by mass, and more preferably from 0.01 to 1 part by mass with respect to 100 parts by mass of polyvinyl acetal.

As the ultraviolet absorber, known ones can be used, and examples thereof may include a benzotriazole-based ultraviolet absorber, a triazine-based ultraviolet absorber and a benzoate-based ultraviolet absorber. The amount of the ultraviolet absorber added is preferably from 10 to 50,000 ppm, and more preferably from 100 to 10,000 ppm by mass with respect to polyvinyl acetal. In addition, one kind of ultraviolet absorber may be used singly or two or more kinds thereof may be used in combination.

As the light stabilizer, a hindered amine-based light stabilizer, for example, "ADEKASTAB LA-57 (trade name)" manufactured by ADEKA CORPORATION is exemplified.

Examples of the functional inorganic compound may include a light reflective material, a light-absorbing material, a thermal conductivity improving material, an electric characteristic improving material, a gas barrier improving material and a mechanical property improving material.

[Encapsulant for solar cell and interlayer film for laminated glass]

The method for manufacturing the sheet of the present invention is not particularly limited, but it is possible to fabricate a sheet by containing a rubber-containing graft polymer powder at from 1 to 100 parts by mass with respect to 100 parts by mass of polyvinyl acetal, blending a predetermined amount of a plasticizer and/or other additives to this if necessary, uniformly kneading the mixture, and forming into a sheet by a known film forming method such as an extrusion method, a calender method, a pressing method, a casting method and an inflation method and to use the sheet as the encapsulant for a solar cell or the interlayer film for laminated glass.

Among the known film forming methods, a method to manufacture a sheet using an extruder is especially suitably employed. The resin temperature during extrusion is preferably from 150 to 250°C, and more preferably from 170 to 230°C. When the resin temperature is too high, polyvinyl acetal will undergo decomposition and the content of volatile substances is likely to increase. On the contrary, when the resin temperature is too low, the content of volatile substances is likely to increase as well. In order to efficiently remove the volatile substances, it is preferable to remove the volatile substances from a vent port of the extruder by reducing the pressure.

In the sheet of the present invention, it is important that the content of chlorine is 50 ppm or less, preferably 30 ppm or less, more preferably 10 ppm or less, even more preferably 6 ppm or less, and still more preferably 3 ppm or less with respect to the sheet. When the content of chlorine is more than 50 ppm, the discoloration of the solar cell module due to the corrosion of the metal component under a high temperature and a high humidity is likely to occur and the power of the solar cell module decreases as a result. On the other hand, the lower limit value of the content of chlorine is not particularly limited, but it is 0.1 ppm from the perspective of the manufacturing method. As the method for measuring the content of chlorine, the content of chlorine can be measured by potentiometric titration in the same manner as Examples described hereafter. Specifically, the concentration of the chloride ion in the sheet can be determined from the titer by a change in electrical conductivity using a 0.001 mol/L aqueous solution of silver nitrate as the titrant and to use this as the content of chlorine.

As described above, in order to set the content of chlorine in the sheet to be within the above range, for example, a method in which the content of chlorine in polyvinyl acetal to be used is lowered is exemplified, and specifically, a method in which a non-chlorine-based catalyst is used as the catalyst used when acetalizing polyvinyl alcohol with an aldehyde is exemplified. As the non-chlorine-based catalyst, those which are described above are used, but sulfuric acid or nitric acid is preferable since a sufficient reaction velocity is obtained and the washing after the reaction is easy, and nitric acid is more preferable since handling property is especially easy. In addition, even in the case of using a chlorine-based catalyst such as hydrochloric acid, it is also possible to lower the content of chlorine by repeatedly washing polyvinyl acetal obtained by acetalization with water or the like after filtration and/or neutralization.

In the sheet of the present invention, the amount of the acidic component eluted by the hot water test and represented by the following Formula (2) is 3.00 KOHmg/g or less, more preferably 1.00 KOHmg/g or less, and even more preferably 0.50 KOHmg/g or less:

[Mathematical Formula 5]

$$\text{(Amount of acidic component eluted by hot water test)} = B \qquad (2)$$

[in Formula (2), B (unit: KOHmg/g) represents a value obtained by dividing a mass (unit: mg) of potassium hydroxide required to neutralize an acidic component present in water after immersing the sheet in hot water having a mass of 10 times as much as the sheet and having a temperature of 85°C for 1000 hours by a mass (unit: g) of the sheet before being immersed]. It is not preferable that the amount of the acidic component eluted by the hot water test be more than 3.00 KOHmg/g since the discoloration of the solar cell module due to the corrosion of the metal component under a high temperature and a high humidity is likely to occur and a decrease in power of the solar cell module is concerned as a result. In addition, it is not preferable since the yellowing of the sheet as the encapsulant for a solar cell is remarkable. The amount of the acidic component eluted by the hot water test can also be a negative value, but it is usually 0 KOHmg/g or more.

The method for measuring the amount of the acidic component eluted by the hot water test will be described below. First, 5 g of the sheet to be the target of measurement is immersed in 50 mL of water and subjected to the immersion treatment at 85°C for 1000 hours. The acid value of water taken after the immersion treatment for 1000 hours is measured in accordance with the provision of JIS K6728: 1977 (provided that, 0.02 mol/L sodium hydroxide is used as the titrant, and after titration, the number of moles of sodium hydroxide used for titration is converted into the mass of equimolar potassium hydroxide, in addition, 50 mL of ion exchanged water is used for the blank measurement), and the value obtained by multiplying the acid value (unit: KOHmg/g) thus obtained by the mass (unit: g) of water is taken as B1 (unit: mg KOH). Thereafter, the value obtained by dividing the above B1 by 5 g of the mass of the sheet before being immersed is taken as the above B (unit: KOHmg/g).

In order to set the amount of the acidic component eluted by the hot water test and represented by Formula (2) above to be within the above range, the amount of the acidic component eluted by the hot water test and represented by Formula (1) is preferably 0.10 KOHmg/g or less, more preferably 0.07 KOHmg/g or less, and even more preferably 0.05 KOHmg/g or less in the rubber-containing graft polymer powder for polyvinyl acetal for a sheet used in the present invention.

Furthermore, it is important to decrease the acidic component contained in polyvinyl acetal in amount, and examples thereof may include a method to remove the acid catalyst for acetalization by sufficiently neutralizing and washing or to add a buffer for pH adjustment. In addition, it is possible to decrease the acidic component in amount by decreasing the amount of the plasticizer used. Among these, it is preferable to add a buffer for pH adjustment since the deacetalization reaction during hot water immersion and the subsequent oxidation reaction are suppressed and the generation of the acidic component can be suppressed as a result.

As the buffer for pH adjustment, those which are known can be used and examples thereof may include a citric acid-citrate salt buffer (citric acid, sodium citrate, and the like), an acetic acid-acetate salt buffer (acetic acid and sodium acetate, potassium acetate, magnesium acetate and the like), a butyric acid- acetate salt buffer (butyric acid and sodium acetate, potassium acetate, magnesium acetate and the like), a citric acid-phosphate salt buffer (citric acid and disodium hydrogen phosphate and the like), a phosphate salt-phosphate salt buffer (sodium dihydrogen phosphate and disodium hydrogen phosphate and the like), a tris(hydroxymethyl)aminomethane-hydrochloric acid buffer, a glycine-sodium hydroxide buffer and a carbonate salt- bicarbonate salt buffer (sodium carbonate and sodium bicarbonate and the like). The buffer to be used may be appropriately selected depending on the corrosion resistance of the metal and the metal oxide to be in contact with, but a buffer having a pH within the range of from 5 to 9 is preferable, and especially an acetic acid-acetate salt buffer, a butyric acid-acetate salt buffer and a phosphate salt-phosphate salt buffer are preferable from the viewpoint of the pH value, handling property and cost.

The amount of the buffer for pH adjustment added is not particularly limited, but it is preferably from 1 to 50,000 ppm, more preferably from 5 to 10,000 ppm, even more preferably from 10 to 5,000 ppm, and still more preferably from 15 to 2,000 ppm based on the mass of polyvinyl acetal.

With regard to the sheet of the present invention, it is preferable that a steel ball not penetrate through a laminated body fabricated by adhering glass having a thickness of 2.8 mm to both surfaces of the sheet when being dropped from a height of 2 m in accordance with the penetration resistance test of JIS R 3212. It is not preferable to use an encapsulant for a solar cell through which a steel ball penetrates in the case of being dropped from a height of 2 m since the impact resistance of the solar cell module to be obtained is not sufficient and it is concerned that the solar cell module fails in the MST32 impact fracture test for safety qualification (IEC61730-2).

The sheet of the present invention is excellent in adhesive property to glass and thus has a feature to be hardly delaminated and is useful as a solar cell module. The adhesive property to glass can be evaluated, for example, by the compression shear strength.

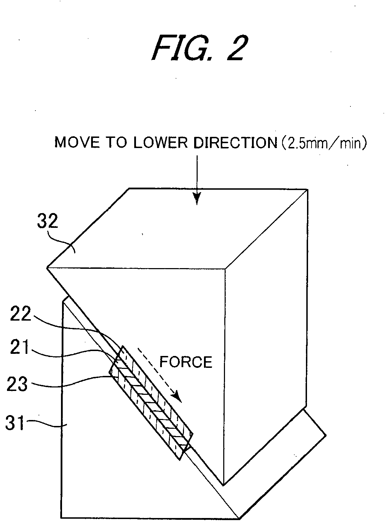

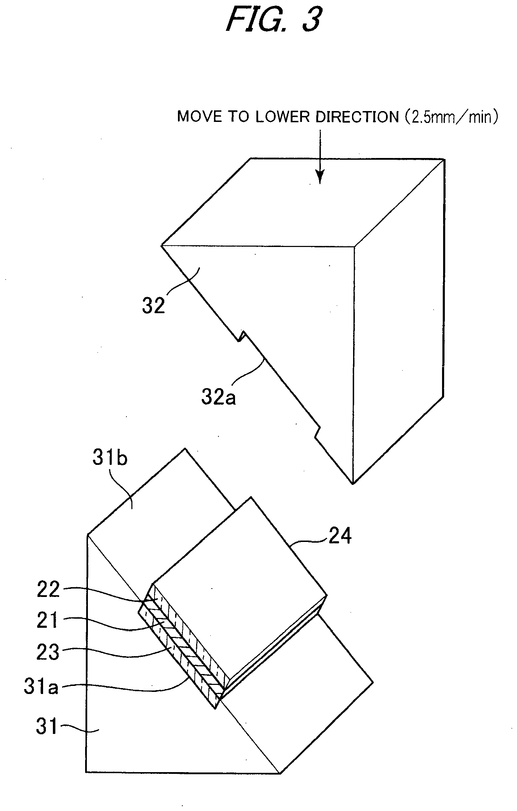

The compression shear strength is measured using a jig for compression shear strength measurement illustrated in Fig. 2 and Fig. 3. First, a laminated glass sample 24 (25 mm in length × 25 mm in width) having an encapsulant 21 (encapsulant for a solar cell or interlayer film for laminated glass) sandwiched between glass 23 and glass 22 is fabricated.

The laminated glass sample 24 is placed in a recess 31a of a jig (lower part) 31 (see Fig. 3). The jig (lower part) 31 is installed on a plane parallel to the ground and the inclined plane having the recess 31a is inclined to the ground by an angle of 45 degrees. The recess 31a is perpendicularly recessed to this inclined plane. The shape of the hollow of the recess 31a and the shape of the bottom surface of the laminated glass sample 24 are the same square of 25 mm × 25 mm, and the laminated glass sample 24 can be installed without being caught in the recess 31a. The glass 23 constituting the laminated glass sample 24 comes in contact with the jig (lower part) 31 in the recess 31a.

The depth of the recess 31a is shallower than the thickness of the laminated glass samples 24, and the upper part of the laminated glass samples 24, namely the portion consisting of the glass 22 is projected on the upper side than an inclined plane 31b of the jig (lower part) 31. In the same manner as the jig (lower part) 31, the shape of the hollow of a recess 32a of a jig (upper part) 32 is a square of 25 mm in length $\times$ 25 mm in width that is the same as the shape of the bottom surface of the laminated glass sample 24, and the glass 22 protruding from the inclined plane 31b comes in contact with the recess 32a of the jig (upper part) 32 and can be engaged. The jig (upper part) 32 is fixed to the crosshead of the compression shear testing machine, but it is fixed to the crosshead of the compression shear testing machine so that the inclined plane having the recess 32a is inclined to the ground by an angle of 45 degrees in the same manner as the inclined plane of the jig (lower part) 31. The recess 32a is perpendicularly recessed to this inclined plane.

The jig (upper part) 32 fixed to the crosshead of the compression shear testing machine is lowered in the direction perpendicular to the ground at a speed of 2.5 mm/min until the recess 32a comes in contact with the glass 22 of the laminated glass sample 24 (see Fig. 3). The crosshead is lowered at a speed of 2.5 mm/min even after the recess 32a of the jig (upper part) 32 is engaged with the upper part of the laminated glass sample 24. As a result, the shear stress is applied to the laminated glass sample 24 and the adhesive failure is caused to the encapsulant 21 and the glass 22 or the glass 23 at a certain point of time. Here, the compression shear strength to be the target for the measurement refers to the shear stress at the time at which the adhesive failure is caused. It is possible to prepare six laminated glass samples 24, to conduct the same test six times and to take the average value thereof as the adhesive strength of the encapsulant. It is known that the error is usually fallen into about a several percent in a case in which the same test is conducted six times and the average value thereof is taken.

As the method for fabricating the laminated glass sample 24 used for the compression shear strength test, for example, a method in which the encapsulant 21 is sandwiched between two sheets of commercially available float glass (thickness of 3 mm, size of 25 mm in length $\times$ 25 mm in width) and the laminated glass sample is then fabricated by employing a vacuum bag method (condition: the temperature is raised from 30°C to 160°C over 60 minutes and then kept at 160°C for 30 minutes).

It is preferable to form an uneven structure on the surface of the sheet of the present invention by a method known in the art such as melt fracture and emboss. The shape of melt fracture and emboss is not particularly limited, and those which are known in the art can be employed.

The film thickness of the sheet as the encapsulant for a solar cell is not particularly limited, but it is preferably from 20 to 10,000 $\mu$m, more preferably from 100 to 3,000 $\mu$m, and even more preferably from 200 to 1,000 $\mu$m. The film thickness of the sheet as the interlayer film for laminated glass is not particularly limited, but it is preferably from 20 to 10,000 $\mu$m, and more preferably from 100 to 3,000 $\mu$m. It is not preferable that the film thickness of the encapsulant for a solar cell or the interlayer film for laminated glass be too thin since lamination cannot be successfully conducted when fabricating a solar cell module or laminated glass and it is not preferable that the film thickness of the encapsulant for a solar cell or the interlayer film for laminated glass be too thick since the cost increases.

The sheet of the present invention can be used as an encapsulant for forming a solar cell module by sealing between a solar cell and a surface side transparent protective member and/or a back surface side protective member. As such a solar cell module, a variety of types can be exemplified. Examples thereof may include those which have a configuration in which the solar cell is sandwiched by an encapsulant on both sides as in "surface side transparent protective member/surface encapsulant/solar cell/back encapsulant/back surface side protective member", those which have a configuration of "surface side transparent protective member/solar cell/encapsulant/back surface side protective member" (superstrate structure), and those which have a configuration of "surface side transparent protective member/encapsulant/solar cell/back surface side protective member" (substrate structure).

Examples of the solar cell constituting the solar cell module may include various solar cells such as a silicon-based solar cell including monocrystalline silicon, polycrystalline silicon and amorphous silicon, a compound semiconductor-based solar cell of elements of Group III to Group V or Group II to Group VI in the periodic table including gallium-arsenide, CIGS and cadmium-telluride, and an organic solar cell including a dye-sensitized organic solar cell and an organic thin film solar cell.

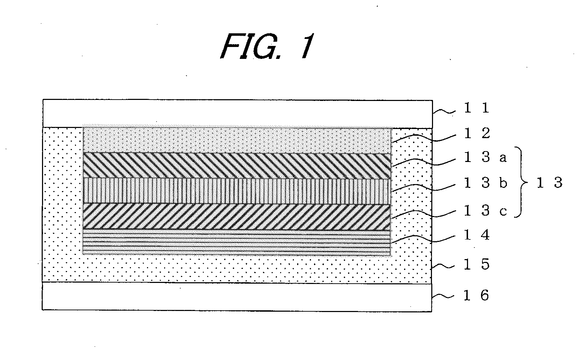

For example, a solar cell module using thin film-based silicon as the solar cell may have a superstrate configuration in which a solar cell such as a silicon power generation element is encapsulated between a glass substrate 11 that is the surface side transparent protective member and a glass substrate 16 that is a back surface side protective member (back cover) via an encapsulant 15 containing polyvinyl butyral as illustrated in Fig. 1. Here, the solar cell refers to the portion consisting of a transparent electrode layer 12, a photoelectric conversion unit 13 and a back surface electrode 14. The photoelectric conversion unit 13 is configured, for example, by a p-layer amorphous Si film as a p-type layer 13a, an i-layer amorphous Si film as an i-type layer 13b and an n-layer amorphous Si film as an n-type layer 13c. Moreover, the sheet of the present invention as the encapsulant for a solar cell excellent in corrosion resistance is useful in a case in which the back surface electrode 14 in contact with the encapsulant 15 is a metal layer such as silver, aluminum, titanium and molybdenum, that is, at least a part of the encapsulant for a solar cell is in contact with the metal layer from the viewpoint of easily exerting the effect that the corrosion of the metal component can be further decreased.

Examples of the surface side transparent protective member constituting the solar cell module may include glass, an acrylic resin, polycarbonate, polyester and a fluorine-containing resin. Among these, glass is preferable from the viewpoint of moisture barrier properties and cost. In addition, as the back surface side protective member, a single-layer or multilayer sheet of a metal, various kinds of thermoplastic resin films or the like can be mentioned, and specific examples thereof may include a single-layer or multilayer sheet of a metal such as tin, aluminum and stainless steel, an inorganic material such as glass, polyester, inorganic vapor deposited polyester, a fluorine-containing resin, polyolefin and the like. Among these, glass is preferable from the viewpoint of moisture barrier properties and cost.

In the present invention, the ends of the solar cell module may be subjected to a waterproof sealing treatment using silicone rubber, butyl rubber and the like in order to further suppress the discoloration due to the corrosion of the metal. However, it is preferable to use as a frameless configuration without subjecting the ends to the waterproof sealing treatment from the viewpoint of cost reduction. The sheet of the present invention as an encapsulant for a solar cell is excellent in corrosion resistance, and thus the encapsulant is especially usefully used for such a frameless configuration. Moreover, the encapsulant is also excellent in impact resistance, and thus it is not necessary to use expensive thermally tempered glass even in the case of employing the frameless configuration.

Upon the manufacture of the solar cell module, a sheet of the encapsulant for a solar cell of the present invention is fabricated in advance and it is possible to form a module having the configuration already described by a method known in the art in which the module is crimped at a temperature at which the encapsulant for a solar cell melts.

In the case of using a vacuum laminating apparatus, for example, a method to laminate the module at a temperature of from 100 to 200°C, particularly from 130 to 170°C under a reduced pressure of from 1 to 30,000 Pa using a known apparatus used for the manufacture of a solar cell module is exemplified. Specifically, in the case of using a vacuum bag or a vacuum ring, it is preferable to laminate the module at from 130 to 170°C under a pressure of about 20,000 Pa as described in EP 1235683 B, for example.

In the case of using a nip roll, for example, a method to conduct the first temporary crimping of the module at a temperature equal to or lower than the flow beginning temperature of polyvinyl acetal and then to conduct the temporary crimping thereof under the condition close to the flow beginning temperature. Specifically, the module may be heated at from 30 to 100°C using an infrared heater or the like, and then degassed using a roll, further heated at from 50 to 150°C and then crimped using a roll.

The autoclaving step additionally conducted after the temporary crimping is carried out, for example, at a temperature of from 130 to 155°C for about 2 hours under a pressure of about from 1 to 1.5 MPa although it depends on the thickness or configuration of the solar cell module.

The solar cell module of the present invention can also be used as a member of a window, a wall, a roof, a sunroom, a soundproof wall, a show window, a balcony, a handrail and the like, a partition glass member of a conference room and the like and a member of home appliances and the like. In addition, the solar cell module can also be applied to a photovoltaic power plant by installing on a massive scale.

The laminated glass of the present invention is one obtained by inserting the sheet of the present invention between two or more sheets of glass consisting of inorganic glass or organic glass and laminating them. In particular, the sheet of the present invention as an interlayer film for laminated glass is excellent in transparency, load bearing characteristics, weather resistance, impact resistance, and corrosion resistance, and thus it is also useful for laminated glass in which at least a part of such an interlayer film for laminated glass is in contact with a functional material.

As the functional material, a material containing a metal is preferable and examples thereof may include a heat sensor, a light sensor, a pressure sensor, a thin film capacitive sensor, a liquid crystal display film, an electrochromic functional film, a heat shielding material, an electroluminescent functional film, a light emitting diode, a camera, an IC tag, an antenna, and an electrode, a wire and the like for connecting them.

The glass used when fabricating laminated glass using the sheet of the present invention is not particularly limited, and organic glass known in the art may be used, such as polymethyl methacrylate and polycarbonate in addition to inorganic glass such as float plate glass, polished plate glass, figured glass, wired-reinforced plate glass and heat-ray absorbing plate glass, and these may be colorless, colored, transparent or non-transparent. One kind of such glass may be used singly or two or more kinds thereof may be used concurrently. In addition, the thickness of the glass is not particularly limited, but it is preferably 100 mm or less.

EXAMPLES

Hereafter, the present invention will be specifically described with reference to Examples, but the present invention is not limited to these Examples. The evaluation method of the raw materials or components used in Examples and Comparative Examples are as follows.

The measurement of polyvinyl alcohol (PVA) used in the present Production Examples, Examples and Comparative Examples, polyvinyl butyral (PVB) manufactured, the rubber-containing graft polymer and the encapsulant for a solar cell or the interlayer film for laminated glass that were produced or used was conducted according to the following methods.

(Average degree of polymerization of PVA)

It was measured on the basis of the provision of JIS K6726: 1994. The average degree of polymerization of the PVB resin is consistent with the average degree of polymerization of polyvinyl alcohol to be a raw material. The results are shown in Table 1.

(Amount of vinyl acetate component in PVB)

It was measured on the basis of the provision of JIS K6728: 1977.

(Amount of vinyl alcohol component in PVB)

It was measured on the basis of the provision of JIS K6728: 1977. In addition, the degree of acetalization of PVB was determined from the amount of the vinyl acetate component in PVB and the amount of the vinyl alcohol component in PVB. The results are shown in Table 1.

(Alkali titer value of PVB)

An ethanol solution of PVB was titrated with hydrochloric acid and the alkali titer value of PVB was evaluated by the quantity (alkali titer value: mL) of 0.01 mol/L hydrochloric acid required for the neutralization titration per 100 g of PVB. The results are shown in Table 1.

(Acid value of PVB)

It was measured on the basis of the provision of JIS K6728: 1977. The results are shown in Table 1.

(Refractive index of PVB)

It was measured on the basis of the A method of JIS K 7142. The results are shown in Table 1.

(Refractive index of rubber-containing graft polymer powder)

It was measured on the basis of JIS K 7142. The results are shown in Table 2.

(Glass transition temperature of rubber-containing graft polymer powder)

It was measured on the basis of the provision of JIS K 7244-4: 1999 and the peak value of tan $\delta$ was adopted. The results are shown in Table 2.

(Conversion rate of monomer into rubber-containing graft polymer)

A sample prepared by diluting 1 g of the rubber-containing graft polymer latex obtained by polymerization with 10 g of acetone was analyzed using a gas chromatograph (model name "7890", manufactured by Agilent Technologies Inc.) and a column (trade name "HP-5", inner diameter of 0.25 mm, length of 30 m, film thickness of 0.25 $\mu$m, manufactured by Agilent Technologies Inc.) to measure the amount of the monomer component remaining in the latex and the polymerization rate of the monomer component was calculated from the amount of the monomer component remaining. As the internal standard substance, methyl isobutyl ketone was used. The results are shown in Table 2.

(Volume average particle size of rubber-containing graft polymer latex)

The particle size of the rubber-containing graft polymer latex was measured using a particle size measuring instrument ELS800 manufactured by OTSUKA ELECTRONICS Co., LTD. The concentration of the rubber-containing graft polymer latex was adjusted to be approximately 0.1% and subjected to the measurement by further diluting if necessary. The results are shown in Table 2.

(Production Example 1: rubber-containing graft polymer powder-1) production method

(Production of rubbery polymer)

Oxygen contained in the substances other than 1,3-butadiene was substituted with nitrogen to obtain a state in which the polymerization reaction is not substantially inhibited. Thereafter, 55 parts of butyl acrylate, 45 parts of 1,3-butadiene, 0.2 part of diisopropylbenzene peroxide, 1 part of potassium tallowate, 0.5 part of sodium N-lauroylsarcosinate as the emulsifier, 0.5 part of sodium pyrophosphate, 0.005 part of ferrous sulfate, 0.3 part of dextrose and 200 parts of deionized water were introduced into an autoclave and the polymerization was conducted at 50°C over 9 hours. As a result, rubbery polymer latex having a conversion rate of monomer of about 97% and a volume average particle size of from 0.07 to 0.08 $\mu$m was obtained.

(Production of acid group-containing copolymer latex for enlargement)

Into a reaction vessel, 0.003 part of ferrous sulfate, 0.009 part of sodium ethylenediaminetetraacetate, 0.3 part of sodium formaldehyde sulfoxylate, 1.725 parts of potassium tallowate, 2.5 parts of sodium dialkylsulfosuccinate and 200 parts of deionized water were added, the internal temperature thereof was raised to 60°C, and then a mixture consisting of 85 parts of butyl acrylate, 15 parts of methacrylic acid and 0.5 part of cumene hydroperoxide was continuously added thereto dropwise over 2 hours to conduct the polymerization. The stirring was further continued for 2 hours, thereby obtaining acid group-containing copolymer latex having a conversion rate of monomer of 97% or more.

(Preparation of graft copolymer)

To a reaction vessel into which the rubbery polymer latex containing 100 parts of polymer solid matter of the rubbery polymer had been introduced, 90 parts of deionized water was added, the internal temperature thereof was raised to 40°C, and the pH was adjusted to be from 7 to 8 with a 4.5% aqueous solution of sodium hydroxide. Thereafter, 1 part of the acid group-containing copolymer latex was added thereto and held for 30 minutes, and 0.35 part of sodium sulfate was added thereto and further held for 10 minutes, thereby obtaining an enlarged rubbery copolymer. The volume average particle size at this time was 0.22 $\mu$m.

To this, 0.15 part of sodium formaldehyde sulfoxylate, 0.000044 part of ferrous sulfate, 0.00013 part of sodium ethylenediaminetetraacetate and 0.5 parts of sodium N-lauroylsarcosinate were added, the internal temperature thereof was raised to 80°C, and a mixture consisting of 45 parts of methyl methacrylate, 5 parts of methyl acrylate, 0.07 part of N-octylmercaptan and 0.062 part of t-butyl hydroperoxide was then started to be added thereto at the time at which the internal temperature thereof reached 60°C and continuously added dropwise over 1 hour to conduct the polymerization. The conversion rate of methyl methacrylate reached almost 100% by further continuing stirring for 30 minutes. The volume average particle size of the rubber-containing graft polymer latex thus obtained was 0.31 $\mu$m. The polymer latex thus obtained was introduced into a 0.83% aqueous solution of calcium acetate at 50°C at a proportion of the latex to the aqueous solution to be 1 to 2, and the mixture was coagulated by heating at 90°C for 5 minutes, washed, dehydrated, and dried at 60°C for 24 hours, thereby obtaining a rubber-containing graft polymer powder-1 of a white powder.

The amount of the acidic component eluted from the rubber-containing graft polymer powder-1 by the hot water test was measured by the measuring method described in the present specification and the result was 0.04 KOHmg/g. In addition, the content of the acidic component in the rubber-containing graft polymer powder-1 was measured by the measuring method described in the present specification and the result was 1.12 KOHmg/g. The refractive index of the rubber-containing graft polymer powder was measured and the result was 1.49. In addition, the glass transition temperature of the rubber-containing graft polymer powder was measured and the result was -58°C.

(Production Example 2: polyvinyl acetal)

Into a 2 m$^3$ reaction vessel equipped with a stirrer, 1700 kg of a 7.5% by mass aqueous solution of PVA (average degree of polymerization of 1000, degree of saponification of 99% by mole), 74.6 kg of butyraldehyde and 0.13 kg of 2,6-di-t-butyl-4-methylphenol were introduced and the whole was cooled to 14°C. To this, 160.1 L of an aqueous solution of nitric acid having a concentration of 20% by mass was added, and the butyralization of PVA was started. The temperature was started to be raised in 10 minutes after the addition was completed and raised to 65°C over 90 minutes, and the reaction was further conducted for 120 minutes. Thereafter, the resultant was cooled to room temperature and PVB precipitated was filtered and then washed 10 times with deionized water having a quantity of 10 times as much as PVB. Thereafter, PVB was sufficiently neutralized using 0.3% by mass aqueous solution of sodium hydroxide, washed 10 times with deionized water having a quantity of 10 times as much as PVB, dehydrated and then dried, thereby obtaining PVB (PVB-1). The analytical results of PVB thus obtained are shown in Table 1.

(Production Example 3: polyvinyl acetal)

Into a 2 m$^3$ reaction vessel equipped with a stirrer, 1700 kg of a 7.5% by mass aqueous solution of PVA (average degree of polymerization of 1000, degree of saponification of 99% by mole), 80.0 kg of butyraldehyde and 0.13 kg of 2,6-di-t-butyl-4-methylphenol were introduced and the whole was cooled to 14°C. To this, 160.1 L of an aqueous solution of nitric acid having a concentration of 20% by mass was added, and the butyralization of PVA was started. The temperature was started to be raised in 10 minutes after the addition was completed and raised to 65°C over 90 minutes, and the reaction was further conducted for 120 minutes. Thereafter, the resultant was cooled to room temperature and PVB precipitated was filtered and then washed 10 times with deionized water having a quantity of 10 times as much as PVB. Thereafter, PVB was sufficiently neutralized using 0.3% by mass aqueous solution of sodium hydroxide, washed 10 times with deionized water having a quantity of 10 times as much as PVB, dehydrated and then dried, thereby obtaining PVB (PVB-2). The analytical results of PVB thus obtained are shown in Table 1.

[Table 1]

|  | PVB-1 | PVB-2 |
|---|---|---|
| Average degree of polymerization of PVB | 1000 | 1000 |
| Degree of acetalization of PVB (% by mole) | 69 | 77 |
| Alkali titer value of PVB (mL) | 7 | 7 |
| Acid value of PVB (KOHmg / g) | 0.03 | 0.03 |
| Refractive index of PVB | 1.49 | 1.49 |

(Example 1)

The pellet obtained by adding 11 parts by mass of the rubber-containing graft polymer powder-1 synthesized in Production Example 1 to 100 parts by mass of PVB (PVB-1) synthesized in Production Example 2, and further adding 25 ppm of acetic acid as the buffer for pH adjustment and 175 ppm of magnesium acetate and 400 ppm of an antioxidant based on the amount of PVB and mixing them was pressed at a pressure of 100 kgf/cm$^2$ and a hot plate temperature of 200°C for 5 minutes, thereby fabricating a polyvinyl butyral sheet having a thickness of 0.76 mm.

1. Evaluation of physical properties (amount of acidic component eluted by hot water test)

With regard to the polyvinyl butyral sheet thus obtained, the amount of the acidic component eluted by the hot water test was measured by the measuring method described in the present specification and the result was 0.46 KOHmg/g.

2. Evaluation of physical properties (adhesive property to glass)

With regard to the polyvinyl butyral sheet thus obtained, the compression shear strength was measured at 25°C by the method described in the present specification. As the laminated glass sample 24, those (6 samples) which were fabricated by a vacuum bag method (condition: the temperature is raised from 30°C to 160°C over 60 minutes and then kept at 160°C for 30 minutes) after sandwiching the above polyvinyl butyral sheet between two sheets of commercially available float glass (thickness of 3 mm, size of 25 mm in length × 25 mm in width) were used. The test was conducted six times for each of the samples. The average value of the measurement results was 33 MPa at 25°C.

3. Evaluation of physical properties (haze)

With regard to the polyvinyl butyral sheet thus obtained, the haze was measured using the laminated glass sample on the basis of JIS K 7136. The measurement result was 1.

4. Evaluation of physical properties (penetration resistance test)

The polyvinyl butyral sheet was sandwiched between two sheets of commercially available float glass (thickness of 2.8 mm, size of 300 mm in length × 300 mm in width), and laminated glass was fabricated using a vacuum laminator (1522N manufactured by Nisshinbo Mechatronics Inc.). Thereafter, a steel ball of 2260 g was dropped on the laminated glass from a height of 2 m according to the penetration resistance test of JIS R 3212. As a result, it was confirmed that the steel ball did not penetrate through the laminated glass (it was acceptable). Next, a steel ball of 2260 g was dropped on the laminated glass from a height of 3 m. As a result, it was confirmed that the steel ball did not penetrate through the laminated glass (it was acceptable).

(Example 2)

A polyvinyl butyral sheet was fabricated in the same manner as in Example 1 except that PVB-2 was used instead of PVB-1. The amount of the acidic component eluted, the adhesive property to glass, the haze and the penetration resistance were evaluated by the same method as in Example 1 using the polyvinyl butyral thus fabricated. The results are presented in Table 2.

(Comparative Example 1)

A polyvinyl butyral sheet was fabricated in the same manner as in Example 1 except that a rubber-containing graft polymer powder C1 (acrylic rubber-containing graft polymer powder, Metablen W377 manufactured by Mitsubishi Rayon Co., Ltd., glass transition temperature of -18°C, content of acidic component of 0.08 KOHmg/g) was used instead of the rubber-containing graft polymer powder-1. The amount of the acidic component eluted, the adhesive property to glass, the haze and the penetration resistance were evaluated by the same method as in Example 1 using the polyvinyl butyral sheet thus fabricated. The results are shown in Table 2.

(Comparative Example 2)

A polyvinyl butyral sheet was fabricated in the same manner as in Example 1 except that a rubber-containing graft polymer powder C2 (silicone/acrylic rubber composite-containing graft polymer powder, Metablen S2006 manufactured by Mitsubishi Rayon Co., Ltd., glass transition temperature of -39°C, content of acidic component of 0.42 KOHmg/g) was used instead of the rubber-containing graft polymer powder-1. The amount of the acidic component eluted, the adhesive property to glass, the haze and the penetration resistance were evaluated by the same method as in Example 1 using the polyvinyl butyral sheet thus fabricated. The results are shown in Table 2.

(Comparative Example 3)

A polyvinyl butyral sheet was fabricated in the same manner as in Example 1 except that a rubber-containing graft polymer powder C3 (butadiene-based rubber-containing graft polymer powder, Metablen C223A manufactured by Mitsubishi Rayon Co., Ltd., glass transition temperature of -77°C, content of acidic component of 3.07 KOHmg/g) was used instead of the rubber-containing graft polymer powder-1. The amount of the acidic component eluted, the adhesive property to glass, the haze and the penetration resistance were evaluated by the same method as in Example 1 using the polyvinyl butyral sheet thus fabricated. The results are shown in Table 2.

(Comparative Example 4)

A polyvinyl butyral sheet was fabricated in the same manner as in Example 1 except that a rubber-containing graft polymer powder was not used. The amount of the acidic component eluted, the adhesive property to glass, the haze and the penetration resistance were evaluated by the same method as in Example 1 using the polyvinyl butyral sheet thus fabricated. The results are shown in Table 2.

[Table 2]

| | | | Example 1 | Example 2 | Comparative Example 1 | Comparative Example 2 | Comparative Example 3 | Comparative Example 4 |
|---|---|---|---|---|---|---|---|---|
| PVB | | PVB-1 (parts by mass) | 100 | - | 100 | 100 | 100 | 100 |
| | | PVB-2((parts by mass) | - | 100 | - | - | - | - |
| Rubber-containing graft polymer powder | | Rubber-con taining graft polymer powder-1 (parts by mass) | 11 | 11 | - | - | - | - |
| | | Rubber-containing graft polymer powder-C1 (parts by mass) | - | - | 11 | - | - | - |
| | | Rubber-containing graft polymer powder-C2 (parts by mass) | - | - | - | 11 | - | - |
| | | Rubber-con taining graft polymer powder-C3 (parts by mass) | - | - | - | - | 11 | - |
| | | Refractive index of rubber-containing graft polvmer powder | 1.49 | 1.49 | 1.49 | 1.46 | 1.52 | - |
| | | Glass transition temperature of rubber-containing graft polymer powder (°C) | -58 | -58 | -18 | -39 | -77 | - |
| | | Amount of acidic component of rubber eluted by hot water test (KOHmg/g) | 0.04 | 0.04 | 0.14 | 0.33 | 0.20 | - |
| | | Content of acidic component of rubber-containing graft polymer powder (KOHmg/g) | 1.12 | 1.12 | 0.08 | 0.42 | 3.07 | - |
| Physical properties of PVB sheet | | Amount of acidic component eluted by hot water test (KOHmg/g) | 0.46 | 0.13 | 4.70 | 8.70 | 7.67 | 0.05 |
| | Adhesive property to glass (MPa) | 25°C | 33 | 30 | 33 | 33 | 33 | 52 |
| | | Difference in refractive index between PVB and rubber-containing graft polymer powder | 0.00 | 0.01 | 0.00 | 0.03 | 0.03 | - |
| | Haze | | 1 | 5 | 1 | 23 | 94 | 1 |
| | Penetration resistance test | 2m | Acceptable | Acceptable | Acceptable | Acceptable | Acceptable | Unacceptable |
| | | 3m | Acceptable | Acceptable | Unacceptable | Acceptable | Acceptable | Unacceptable |

From Examples and Comparative Examples, it is understood that the PVB sheets using the rubber-containing graft polymer powder which satisfies the requirements of the present application have a small amount of the acidic component eluted by the hot water test and can be used as an encapsulant for a solar cell excellent in impact resistance, corrosion resistance, transparency and weather resistance. When Example 1 is compared with Comparative Example 1, the amount of the acidic component eluted from the PVB sheet of Example 1 by the hot water test is smaller than that of Comparative example 2 and the PVB sheet of Example 1 is superior to that of Comparative Example 2 in corrosion resistance, weather resistance and impact resistance although the content of the acidic component in the rubber-containing graft polymer powder of Comparative Example 2 is smaller than that in the rubber-containing graft polymer powder of Example 1.

Reference Signs List

11 Glass substrate
12 Transparent electrode layer
13 Photoelectric conversion unit
13a p-type layer
13b i-type layer
13c n-type layer
14 Back surface electrode
15 Encapsulant
16 Glass substrate
21 Encapsulant
22 Glass
23 Glass
24 Laminated glass sample
31 Jig for compression shear strength measurement (lower part)
31a Recess
31b Inclined plane
32 Jig for compression shear strength measurement (upper part)
32a Recess

## Claims

1. A sheet comprising:

    a rubber-containing graft polymer powder at from 1 to 100 parts by mass with respect to 100 parts by mass of polyvinyl acetal, wherein
    an amount of an acidic component eluted by a hot water test and represented by the following Formula (2) is 3.00 KOHmg/g or less:
    [Mathematical Formula 2]

$$\text{(Amount of acidic component eluted by hot water test)} = B \qquad (2),$$

    wherein B (unit: KOHmg/g) represents a value obtained by dividing a mass (unit: mg) of potassium hydroxide required to neutralize an acidic component present in water after immersing the sheet in hot water having a mass of 10 times as much as the sheet and having a temperature of 85°C for 1000 hours by a mass (unit: g) of the sheet before being immersed, and
    wherein the rubber-containing graft polymer powder is obtained by conducting the graft polymerization of a vinyl monomer in the presence of a rubbery polymer obtained by polymerizing a conjugated diene (x1) and an acrylic acid alkyl ester (x2) having an alkyl group having from 2 to 8 carbon atoms and coagulating this.

2. The sheet according to claim 1, wherein
the rubber-containing graft polymer powder has 0.10 KOHmg/g or less of an amount of an acidic component eluted by a hot water test and represented by the following Formula (1):
[Mathematical Formula 1]

$$\text{(Amount of acidic component eluted by hot water test)} = A \qquad (1),$$

and

wherein A (unit: KOHmg/g) represents a value obtained by dividing a mass (unit: mg) of potassium hydroxide required to neutralize an acidic component present in water after immersing the rubber-containing graft polymer powder in hot water having a mass of 10 times as much as the rubber-containing graft polymer powder and having a temperature of 85°C for 250 hours by a mass (unit: g) of the rubber-containing graft polymer powder before being immersed.

3. The sheet according to claim 1 or 2,
   wherein the rubbery polymer is obtained by polymerizing the conjugated diene (x1) at from 25 to 75% by mass, the acrylic acid alkyl ester (x2) having an alkyl group having from 2 to 8 carbon atoms at from 75 to 25% by mass and copolymerizable another monomer (x3) at from 0 to 5% by mass.

4. The sheet according to any one of claims 1 to 3,
   wherein the rubber-containing graft polymer powder is produced by supplying a coagulant containing an alkaline earth metal ion to rubber-containing graft polymer latex obtained by emulsion polymerization and coagulating the latex.

5. The sheet according to claim 4,
   wherein the rubber-containing graft polymer powder is produced by supplying a coagulant containing an alkaline earth metal ion to rubber-containing graft polymer latex obtained by emulsion polymerization using a weak acid-based emulsifier and coagulating the latex.

6. The sheet according to claim 5,
   wherein the weak acid-based emulsifier is a fatty acid-based emulsifier.

7. The sheet according to any one of claims 4 to 6,
   wherein a volume average particle size of the rubber-containing graft polymer latex is from 0.13 to 0.80 $\mu$m.

8. The sheet according to any one of claims 1 to 7, wherein
   a difference in refractive index between a film made of the polyvinyl acetal and a film made of the rubber-containing graft polymer powder is 0.02 or less, and
   a steel ball does not penetrate through a laminated body fabricated by adhering glass having a thickness of 2.8 mm to both surfaces of the sheet when being dropped on the laminated body from a height of 2 m in accordance with the penetration resistance test of JIS R 3212.

9. The sheet according to claim 8, wherein a steel ball does not penetrate through the laminated body when being dropped on the laminated body from a height of 3 m in accordance with the penetration resistance test of JIS R 3212.

10. A solar cell or laminated glass using:
    the sheet according to any one of claims 1 to 9.

**Patentansprüche**

1. Folie umfassend:

   ein kautschukhaltiges Pfropfpolymerpulver zu 1 bis 100 Massenteilen bezogen auf 100 Massenteile an Polyvinylacetal, wobei
   eine Menge einer sauren Komponente, eluiert durch einen Heißwassertest und dargestellt durch die folgende Formel (2), 3,00 KOHmg/g oder weniger beträgt:
   [Mathematische Formel 2]

$$(\text{Menge an saurer Komponente, eluiert durch einen Heißwassertest}) = B \quad (2),$$

wobei B (Einheit: KOHmg/g) einen Wert darstellt, erhalten durch das Dividieren einer Masse (Einheit: mg) von Kaliumhydroxid, die benötigt wird zum Neutralisieren einer in Wasser vorhandenen sauren Komponente nach dem Eintauchen der Folie in heißes Wasser mit einer Masse, die der 10-fachen der Folie entspricht, und mit einer Temperatur von 85°C für 1000 Stunden, durch eine Masse (Einheit: g) der Folie vordem Eintauchen, und wobei das kautschukhaltige Pfropfpolymerpulver erhalten ist durch das Durchführen der Pfropfpolymerisation eines Vinylmonomers in Gegenwart eines gummiartigen Polymers, erhalten durch das Polymerisieren eines konjugierten Diens (x1) und eines Acrylsäurealkylesters (x2) mit einer Alkylgruppe mit 2 bis 8 Kohlenstoffatomen, und das Koagulieren davon.

2. Folie nach Anspruch 1, wobei
das kautschukhaltige Pfropfpolymerpulver 0,10 KOHmg/g oder weniger einer Menge einer sauren Komponente, eluiert durch einen Heißwassertest und dargestellt durch die folgende Formel (1), aufweist:
[Mathematische Formel 1]

$$(\text{Menge an saurer Komponente, eluiert durch einen Heißwassertest}) = A \quad (1),$$

und
wobei A (Einheit: KOHmg/g) einen Wert darstellt, erhalten durch das Dividieren einer Masse (Einheit: mg) von Kaliumhydroxid, die benötigt wird zum Neutralisieren einer in Wasser vorhandenen sauren Komponente nach dem Eintauchen des kautschukhaltigen Pfropfpolymerpulvers in heißes Wasser mit einer Masse, die der 10-fachen des kautschukhaltigen Pfropfpolymerpulvers entspricht, und mit einer Temperatur von 85°C für 250 Stunden, durch eine Masse (Einheit: g) des kautschukhaltigen Pfropfpolymerpulvers vor dem Eintauchen.

3. Folie nach Anspruch 1 oder 2,
wobei das gummiartige Polymer erhalten ist durch das Polymerisieren des konjugierten Diens (x1) zu 25 bis 75 Massen-%, des Acrylsäurealkylesters (x2) mit einer Alkylgruppe mit 2 bis 8 Kohlenstoffatomen zu 75 bis 25 Massen-% und eines copolymerisierbaren anderen Monomers (x3) zu 0 bis 5 Massen-%.

4. Folie nach einem der Ansprüche 1 bis 3,
wobei das kautschukhaltige Pfropfpolymerpulver hergestellt ist durch das Zuführen eines Koagulationsmittels, enthaltend ein Erdalkalimetallion, zu kautschukhaltigem Pfropfpolymerlatex, erhalten durch Emulsionspolymerisation, und das Koagulieren des Latex.

5. Folie nach Anspruch 4,
wobei das kautschukhaltige Pfropfpolymerpulver hergestellt ist durch das Zuführen eines Koagulationsmittels, enthaltend ein Erdalkalimetallion, zu kautschukhaltigem Pfropfpolymerlatex, erhalten durch Emulsionspolymerisation unter Verwendung eines Emulgators auf Basis einer schwachen Säure, und das Koagulieren des Latex.

6. Folie nach Anspruch 5,
wobei der Emulgator auf Basis einer schwachen Säure ein Emulgator auf Basis einer Fettsäure ist.

7. Folie nach einem der Ansprüche 4 bis 6,
wobei eine volumengemittelte Teilchengröße des kautschukhaltigen Pfropfpolymerlatex von 0,13 bis 0,80 $\mu$m beträgt.

8. Folie nach einem der Ansprüche 1 bis 7, wobei
eine Differenz im Brechungsindex zwischen einem Film, gebildet aus dem Polyvinylacetal, und einem Film, gebildet aus dem kautschukhaltigen Pfropfpolymerpulver, 0,02 oder weniger beträgt und
eine Stahlkugel nicht hindurchdringt durch einen laminierten Körper, hergestellt durch das Anhaften von Glas mit einer Dicke von 2,8 mm an beide Oberflächen der Folie, wenn fallengelassen auf den laminierten Körper aus einer Höhe von 2 m gemäß dem Pentrationswiderstandstest von JIS R 3212.

9. Folie nach Anspruch 8, wobei eine Stahlkugel nicht hindurchdringt durch den laminierten Körper, wenn fallengelassen auf den laminierten Körper aus einer Höhe von 3 m gemäß dem Pentrationswiderstandstest von JIS R 3212.

**10.** Solarzelle oder Verbundglas, verwendend die Folie nach einem der Ansprüche 1 bis 9.

**Revendications**

**1.** Feuille comprenant :

une poudre de polymère greffé contenant du caoutchouc en une proportion située dans l'intervalle allant de 1 à 100 parties en masse par rapport à 100 parties en masse de polyvinylacétal, où la quantité de composant acide élué par un test à l'eau chaude et définie par la formule (2) suivante se situe à 3,00mg KOH/g ou moins :
[Formule mathématique 2]

$$\text{(quantité de composant acide élué par le test à l'eau chaude)} = B \quad (2),$$

où B (unité= mg KOH/g) représente une valeur obtenue en divisant la masse (unité : mg) d'hydroxyde de potassium nécessaire pour neutraliser le composant acide présent dans l'eau après immersion de la feuille dans une quantité d'eau chaude dont la masse est 10 fois supérieure à la masse de la feuille à une température de 85°C pendant 1000 heures par la masse (unité : g) de la feuille avant immersion, et
où la poudre de polymère greffé contenant du caoutchouc est obtenue par polymérisation par greffage d'un monomère vinylique en présence d'un polymère caoutchouteux obtenu par polymérisation d'un diène conjugué (x1) et d'un ester alkylique d'acide acrylique (x2) dont le groupe alkyle comporte 2 à 8 atomes de carbone, et par coagulation.

**2.** Feuille selon la revendication 1, où
la poudre de polymère greffé contenant du caoutchouc présente une quantité de composé acide élué par le test à l'eau chaude et représentée par la formule (1) suivante de 0,10 mg KOH/g :
[Formule mathématique 1]

$$\text{(quantité de composant acide élué par le test à l'eau chaude)} = A \quad (1),$$

où A (unité= mg KOH/g) représente une valeur obtenue en divisant la masse (unité : mg) d'hydroxyde de potassium nécessaire pour neutraliser le composant acide présent dans l'eau après immersion de la poudre de polymère greffé contenant du caoutchouc dans une quantité d'eau chaude dont la masse est 10 fois supérieure à la masse de la poudre de polymère greffé contenant du caoutchouc à une température de 85°C pendant 250 heures par la masse (unité : g) de la poudre de polymère greffé contenant du caoutchouc avant immersion.

**3.** Feuille selon la revendication 1 ou 2,
où le polymère caoutchouteux est obtenu par polymérisation de 25 à 75% en masse du diène conjugué (x1), 75 à 25% en masse de l'ester alkylique d'acide acrylique (x2) dont le groupe alkyle comporte 2 à 8 atomes de carbone et de 0 à 5% en masse d'un autre monomère copolymérisable (x3)

**4.** Feuille selon l'une quelconque des revendications 1 à 3,
où la poudre de polymère greffé contenant du caoutchouc est produite par addition d'un coagulant contenant un ion de métal alcalino-terreux au latex de polymère greffé contenant du caoutchouc obtenu par polymérisation par émulsion, et coagulation du latex.

**5.** Feuille selon la revendication 4,
où la poudre de polymère greffé contenant du caoutchouc est produite par addition d'un coagulant contenant un ion de métal alcalino-terreux au latex de polymère greffé contenant du caoutchouc obtenu par polymérisation par émulsion en utilisant une émulsifiant à base d'acide faible, et coagulation du latex.

**6.** Feuille selon la revendication 5,

où l'émulsifiant à base d'acide faible est un émulsifiant à base d'acide gras.

7. Feuille selon l'une quelconque des revendications 4 à 6,
   où la taille moyenne en volume des particules du latex de polymère greffé contenant du caoutchouc se situe dans l'intervalle allant de 0,13 à 0,80 μm.

8. Feuille selon l'une quelconque des revendications 1 à 7, où
   la différence d'indice de réfraction entre un film composé du polyvinylacétal et d'un film composé de la poudre de polymère greffé contenant du caoutchouc se situe à 0,02 ou moins, et
   une bille d'acier ne pénètre pas un corps stratifié préparé par adhésion de verre ayant une épaisseur de 2,8 mm aux deux faces de la feuille lorsqu'elle chute sur le corps stratifié depuis une hauteur de 2 m selon le test de résistance à la pénétration JIS R 3212.

9. Feuille selon la revendication 8, où une bille d'acier ne pénètre pas un corps stratifié lorsqu'elle chute sur le corps stratifié depuis une hauteur de 3 m selon le test de résistance à la pénétration JIS R 3212.

10. Cellule solaire ou corps stratifié comprenant la feuille selon l'une quelconque des revendications 1 à 9.

FIG. 1

# FIG. 2

MOVE TO LOWER DIRECTION (2.5mm/min)

FORCE

32

22
21
23
31

# FIG. 3

MOVE TO LOWER DIRECTION (2.5mm/min)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006013505 A
- WO 2009151952 A2
- JP 2003040654 A
- WO 03033583 A1
- EP 1235683 A

**Non-patent literature cited in the description**

- THE SOLAR STANDARD No. 1. *APPLIED MATERI-ALS,* May 2008, http://www.appliedmaterials.com/products/assets/newsletters/solar_ newsletter_may2008_japan.pdf>